# EUROPÄISCHE PATENTSCHRIFT

(11) **EP 3 129 443 B1**
(45) Veröffentlichungstag und Bekanntmachung des Hinweises auf die Patenterteilung: **28.04.2021**
(21) Anmeldenummer: 15712296.1
(22) Anmeldetag: 17.03.2015
(51) Int. Cl.: C09J 11/08, C09J 7/22, C09J 7/38, C09J 7/25, C09J 153/00, H01L 21/56, H01L 23/29, H01L 23/31, C08L 63/00

(54) **KLEBEBAND FÜR DIE KAPSELUNG EINER ORGANISCHEN ELEKTRONISCHEN ANORDNUNG**
ADHESIVE TAPE FOR ENCAPSULATING AN ORGANIC ELECTRONIC ARRANGEMENT
RUBAN ADHÉSIF POUR L'ENCAPSULATION D'UN DISPOSITIF ORGANIQUE ÉLECTRONIQUE

(30) Priorität: 11.04.2014 DE 102014207074
(43) Veröffentlichungstag der Anmeldung: 15.02.2017
(73) Patentinhaber: tesa SE, 22848 Norderstedt (DE)
(72) Erfinder: KEITE-TELGENBÜSCHER, Klaus, 22529 Hamburg (DE); ROMPF, Julia, 20249 Hamburg (DE); STOLZE, Janika, 29587 Natendorf (DE)
(74) Vertreter: tesa SE
(86) Internationale Anmeldenummer: PCT/EP2015/055480
(87) Internationale Veröffentlichungsnummer: WO 2015/154947

(56) Entgegenhaltungen:
- EP-A2- 2 639 275
- WO-A1-2010/033571
- WO-A1-2014/001005
- JP-A- 2005 263 994
- JP-A- 2008 310 267
- US-A1- 2010 068 421
- US-B1- 6 288 172

## Beschreibung

Die vorliegende Erfindung betrifft einen Klebstoff sowie ein Klebeband für die Kapselung einer organischen elektronischen Anordnung und ein Verfahren für dessen Anwendung.

### Stand der Technik:

Optoelektronische Anordnungen werden immer häufiger in kommerziellen Produkten verwendet oder stehen kurz vor der Markteinführung. Derartige Anordnungen umfassen anorganische oder organische elektronische Strukturen, beispielsweise organische, metallorganische oder polymere Halbleiter oder auch Kombinationen davon. Die entsprechenden Produkte sind je nach gewünschter Anwendung starr oder flexibel ausgebildet, wobei eine zunehmende Nachfrage nach flexiblen Anordnungen besteht. Die Herstellung derartiger Anordnungen erfolgt häufig durch Druckverfahren wie Hochdruck, Tiefdruck, Siebdruck, Flachdruck oder auch so genanntes "non impact printing" wie etwa Thermotransferdruck, Tintenstrahldruck oder Digitaldruck. Vielfach werden aber auch Vakuumverfahren wie beispielsweise Chemical Vapor Deposition (CVD), Physical Vapor Deposition (PVD), plasmaunterstützte chemische oder physikalische Depositionsverfahren (PECVD), Sputtern, (Plasma-)Ätzen oder Bedampfung verwendet. Die Strukturierung erfolgt in der Regel durch Masken.

Als Beispiele für bereits kommerziell erhältliche oder in ihrem Marktpotential interessante optoelektronische Anwendungen seien hier elektrophoretische oder elektrochrome Aufbauten oder Displays, organische oder polymere Leuchtdioden (OLEDs oder PLEDs) in Anzeige- und Display-Vorrichtungen oder als Beleuchtung genannt, ferner Elektrolumineszenzlampen, Licht emittierende elektrochemische Zellen (LEECs), organische Solarzellen wie Farbstoff- oder Polymersolarzellen, anorganische Dünnschichtsolarzellen, zum Beispiel auf der Basis von Silizium, Germanium, Kupfer, Indium und Selen, Perowskitsolarzellen, oder auch organische Laserdioden, organische oder anorganische Sensoren angeführt.

Demgemäß wird in dieser Schrift unter einer organischen optoelektronischen Anordnung eine elektronische Anordnung verstanden, die zumindest einen elektronisch funktionalen, zumindest teilweise organischen Bestandteil umfasst - zum Beispiel metallorganische Verbindungen - oder deren elektronisch funktionaler Aufbau eine Dicke von weniger als 20 µm aufweist.

Damit sind unter diesem Begriff auch zum Beispiel anorganische Dünnschichtsolarzellen und anorganische elektrochrome Schichtaufbauten umfasst. Auch dickere elektrolumineszierende Aufbauten mit anorganischen Partikeln sind umfasst, sofern organische, zum Beispiel polymere, Schichten oder Matrixmaterialien zur Einbettung der Partikel verwendet werden, da hier die organischen Materialien als Dielektrikum eine elektronische Funktion übernehmen.

Unter elektronisch funktionalen Bestandteilen sind demgemäß zumindest aber nicht ausschließlich alle in einem elektronischen Aufbau zwischen den Kontaktelektroden (zum Beispiel Anode und Kathode) und gegebenenfalls verwendeten weiteren elektrisch leitfähigen Schichten liegenden Materialien zu verstehen sowie die Elektrodenschichten selbst.

Nicht umfasst vom Begriff der organischen elektronischen Anordnung sind demgemäß klassische, auf Halbleiterwafern basierende elektronische Anordnungen, da deren Aufbau in der Regel dicker als 20 µm ist.

Synonym verwendet werden in dieser Schrift auch verkürzte Begriffe wie "elektronische Anordnung" oder "elektronischer Aufbau", sofern sich nicht aus dem Zusammenhang eine andere Bedeutung erschließt.

Als technische Herausforderung für die Realisierung einer ausreichenden Lebensdauer und Funktion von optoelektronischen Anordnungen auf dem Gebiet der anorganischen und organischen Optoelektronik, ganz besonders der organischen Optoelektronik, ist ein Schutz der darin enthaltenen Komponenten vor Permeaten zu sehen. Als Permeate werden dabei in der Regel gasförmige oder flüssige Stoffe angesehen, die in einen Festkörper eindringen und diesen gegebenenfalls durchdringen beziehungsweise durchwandern. Dementsprechend können viele niedermolekulare organische oder anorganische Verbindungen Permeate sein, wobei im vorliegend beschriebenen Zusammenhang Wasserdampf und Sauerstoff von besonderer Bedeutung sind.

Eine Vielzahl von optoelektronischen Anordnungen - besonders bei Verwendung von organischen Materialien - ist sowohl gegen Wasserdampf als auch gegen Sauerstoff empfindlich. Während der Lebensdauer der elektronischen Anordnungen ist deshalb ein Schutz durch eine Verkapselung erforderlich, da andernfalls die Leistung über den Anwendungszeitraum nachlässt. Es können sich beispielsweise durch eine Oxidation der Bestandteile von Licht emittierenden Anordnungen wie Elektrolumineszenz-Lampen (EL-Lampen) oder organischen Leuchtdioden (OLED) die Leuchtkraft, bei elektrophoretischen Displays (EP-Displays) der Kontrast oder bei Solarzellen die Effizienz innerhalb kurzer Zeit drastisch verringern.

Insbesondere auf dem Gebiet der organischen Optoelektronik gibt es daher einen hohen Bedarf für flexible Klebelösungen, die eine Barriere für Permeate wie Sauerstoff und/oder Wasserdampf darstellen. Im Stand der Technik sind bereits einige Ansätze für derartige Klebelösungen zu finden.

Durch eine Abdeckung, die für permeationsfähige Substanzen undurchlässig ist, können diese von der elektronischen Anordnung ferngehalten werden. Diese Abdeckung wird üblicherweise auf der elektronischen Anordnung und/oder auf den der elektronischen Anordnung angrenzenden Bereichen des Substrates, auf dem die Anordnung vorliegt, verklebt.

Für permeationsfähige Substanzen undurchlässige Abdeckungen können beispielweise vorliegen in Form einer undurchlässigen Schicht einer Klebemasse, die gegebenenfalls nachzubehandeln, zu stabilisieren oder ihrerseits abzudecken ist, oder in Form einer undurchlässigen Schicht eines starren oder flexiblen Materials, die vollflächig oder zumindest in den Randbereichen verklebt wird und so die elektronische Anordnung verkapselt.

Zur Ausbildung einer Klebeschicht und zur Verklebung von Abdeckmaterialien werden häufiger Flüssigklebstoffe und Adhäsive auf Basis von Epoxiden als Barriereklebemassen verwendet, wie sie beispielsweise in WO 98/21287 A1, US 4,051,195 A und US 4,552,604 A beschrieben sind. Ihr Haupteinsatzgebiet sind Randverklebungen starrer Anordnungen, aber auch mäßig flexible Anordnungen. Die Aushärtung erfolgt thermisch oder mittels UV-Strahlung.

Der Einsatz dieser flüssigen Klebstoffe bringt allerdings auch eine Reihe von unerwünschten Effekten mit sich. So können niedermolekulare Bestandteile (VOCs - volatile organic compounds) die empfindlichen elektronischen Strukturen der Anordnung schädigen und die Produktion erschweren. Der Klebstoff muss darüber hinaus aufwändig auf jeden einzelnen Bestandteil der Anordnung aufgebracht werden. Die Anschaffung von teuren Dispensern und Fixiereinrichtungen ist notwendig, um eine genaue Positionierung zu gewährleisten. Die Art der Auftragung verhindert zudem einen schnellen kontinuierlichen Prozess. Im anschließend erforderlichen Laminationsschritt kann aufgrund der geringen Viskosität das Erreichen einer definierten Schichtdicke und Verklebungsbreite erschwert sein.

Eine vorteilhafte Alternative ist der Einsatz von Haft- oder Heißschmelzklebern zur Versiegelung von optoelektronischen Aufbauten. Unter den insbesondere vorteilhaften Haftklebemassen werden dabei bevorzugt solche eingesetzt, die nach der Verklebung durch eingebrachte Energie (zum Beispiel aktinische Strahlung oder Wärme) vernetzbar sind. Derartige Massen werden beispielsweise in US 2006/0100299 A1 und WO 2007/087281 A1 beschrieben. Ihr Vorteil liegt insbesondere darin, dass durch die Vernetzung die Barrierewirkung der Klebemassen verbessert werden kann.

Ebenso ist die Verwendung von Heißschmelzklebemassen im Stand der Technik bekannt. Vielfach werden hier Copolymere des Ethylens eingesetzt, zum Beispiel Ethylen-Ethylacetat (EEA), Ethylen-Acrylsäure-Copolymer (EAA), Ethylen-Butylacrylat (EBA) oder Ethylen-Methylacrylat (EMA). Insbesondere für auf Siliziumwafern basierende Solarzellenmodule werden in der Regel vernetzende Ethylen-Vinylacetat-(EVA)-Copolymere eingesetzt. Die Vernetzung findet während des Versiegelungsprozesses unter Druck und bei Temperaturen oberhalb von etwa 120 °C statt. Dieser Prozess ist für viele auf organischen Halbleitern basierende oder in Dünnschichtverfahren hergestellte optoelektronische Aufbauten aufgrund der hohen Temperaturen und der mechanischen Belastung durch den Druck nachteilig. Synthesekautschuke wie solche Copolymere des Ethylens weisen in der Regel auch eine Wasserdampfpermeationsrate von mehr als 100g/m²d auf und sind daher für die Verkapselung von organischen optoelektronischen Aufbauten nicht geeignet.

Für Barriereklebemassen werden in Heißschmelzklebemassen aufgrund der geringen Polarität bevorzugt amorphe Polyolefine eingesetzt. Der Vorteil der amorphen Polyolefine als Grundstoffe für Schmelzklebstoffe liegt darin, dass es sich um gesättigte Polymere mit sehr guter Wärmestabilität der Schmelze während der Verarbeitung handelt, weiterhin zeichnen sie sich durch niedrige Schmelzviskositäten aus und weisen in Verbindung mit entsprechenden Rezepturbestandteilen (Kohlenwasserstoffharze, Wachse, Weichmacher) günstige Haftungseigenschaften auch gegenüber schwer klebbaren Substraten auf. Wachse bewirken als Zusatz zu verschiedenen Klebstoffarten (zum Beispiel bei Schmelz- und Haftklebstoffen) eine Verbesserung der Adhäsionseigenschaften, der Klebrigkeit (Tack), der Stabilität sowie eine Verminderung der Schmelzviskosität (siehe Habenicht: Kleben, 6. Auflage, 2009, Seiten 71 und 156 f).

Wichtige Wachstypen sind (Habenicht, a.a.O.):
- Paraffinwachse mit Schmelzpunkten im Bereich von 45 bis70 °C und Molgewichten zwischen 225 und 500,
- mikrokristalline Wachse mit Schmelzpunkten im Bereich von 60 bis 95 °C; neben linearen Kohlenwasserstoffen sind auch verzweigte und ringförmige Kohlenwasserstoffe vorhanden,
- synthetische Fischer-Tropsch-Wachse mit Schmelzpunkten im Bereich von 100 bis 115 °C,
- Polyethylenwachse mit Schmelzbereichen zwischen 85 und 140 °C und Molgewichten im Bereich von 500 bis 3500 g/Mol.
Die Wachse sind in der Regel molekular in dem Basispolymer der Heißschmelzklebemasse verteilt. In seltenen Fällen liegen sie auch als Partikel vor, wie zum Beispiel in EP 0 257 545 B1. Dies ist auch von Haftklebemassen bekannt, wie zum Beispiel in EP 0 401 509 A1.

Heißschmelzklebemassen auf der Basis von Blockcopolymeren oder funktionalisierten Polymeren sind beispielsweise in WO 2008/036707 A2, WO 2003/002684 A1, JP 2005-298703 A und US 2004/0216778 A1 beschrieben. Ein Vorteil dieser Klebemassen ist, dass durch die Klebstoffe selbst keine oder nur sehr wenig Substanz in den zu verkapselnden Aufbau eingebracht wird, die den Aufbau selbst schädigt, wohingegen dieses Problem vor allem bei reaktiven Flüssigklebersystemen, insbesondere solchen auf Acrylat- oder Epoxidharzbasis, relevant ist. Aufgrund der hohen Anzahl reaktiver Gruppen weisen diese Systeme eine relativ hohe Polarität auf, so dass insbesondere Wasser darin enthalten ist. Die Menge liegt in der Regel im Bereich von weniger als 100 ppm bis hin zu mehr als 1 %. Unter anderem auch aus diesem Grund werden solche Flüssigkleber - wie schon vorstehend erwähnt - vornehmlich als Randversiegelung der elektronischen Anordnungen eingesetzt, wobei sie nicht in direktem Kontakt mit den aktiven elektronischen Materialien stehen.

Handelsübliche Klebebänder sind ebenfalls üblicherweise für Permeate mehr oder weniger stark durchgängig, daher müssen die Klebebänder mit einer Barrierefunktion für eben diese Permeate versehen werden. Eine weitere Maßnahme ist daher die Ausstattung des Klebstoffs und/oder des Substrats und/oder der Abdeckung des elektronischen Aufbaus mit solchen permeat-bindenden Eigenschaften, also insbesondere mit solchen Substanzen, die in der Lage sind, die Permeate zu sorbieren und somit nicht zur elektronischen Anordnung vorzulassen. Solche zur Sorption permeationsfähiger Substanzen befähigten Materialien werden als Gettermaterialien oder auch kurz als Getter bezeichnet. Nachteilig an der Ausstattung des Klebstoffs mit bindenden Eigenschaften ist die Beeinträchtigung der Klebeigenschaften durch das Gettermaterial. Insbesondere wenn dieses partikulär im Klebstoff vorliegt, nimmt es an der Kontaktfläche zum Verklebungsuntergrund Fläche ein, die nicht mehr zur Verklebung zur Verfügung steht. Im Stand der Technik, so in der WO 2003/065470 A1, wird gelehrt, dass die Menge des in eine Klebemasse eingebrachten Gettermaterials so hoch wie möglich sein sollte, ohne die Klebeigenschaften unzulässig stark zu beeinträchtigen. Hier wird ein Gehalt im Bereich von 5 bis 95 Gew.-% für geeignet gehalten, bevorzugt 15 bis 50 Gew.-%. Es werden ausschließlich anorganische Gettermaterialien verwendet. Der Zusatz von solchen Mengen von in der Regel partikularen, anorganischen Gettermaterialien in die Klebemasse führt zu einer Eintrübung derselben sowie zu einem erheblichen Verlust von Transparenz.

In WO 2014/001005 A1 wird ergänzend ein Gehalt von Gettermaterial von weniger als 2 Gew.-% vorgeschlagen, um die genannten Nachteile abzumildern. In einer bevorzugten Ausführungsform ist hier der Klebstoff im sichtbaren Licht des Spektrums (Wellenlängenbereich von etwa 400 nm bis 800 nm) transparent und/oder zeigt einen Haze kleiner 5,0 %, bevorzugt kleiner 2,5 %.

In spezifischen optoelektronischen Aufbauten ist eine Transluzenz des vom Licht durchstrahlten Teils des Aufbaus gewünscht, um zum Beispiel die Lichtaus- oder-einkopplung zu unterstützen. Insbesondere bei flächigen Leuchtelementen kann die dadurch erhaltene Lichtstreuung zu einer Homogenisierung des Leuchtbildes beitragen, so dass Inhomogenitäten bei der Herstellung der lichtemittierenden Struktur verschleiert werden können.

Im Stand der Technik werden in der Regel zusätzliche Lichtauskopplungs- oder Lichtverteilungsschichten im Aufbau einer optoelektronischen Anordnung verwendet. Die wesentlichen Ansätze sind
- Strukturierte Substrate und Abdeckschichten
- Substrate oder Abdeckungen mit hohem Brechungsindex
- Auskopplungsfilme
- Holografische oder brechende Schichten oder Mehrschichtsysteme
- zusätzliche Dünnschichten direkt angrenzend an die lichtemittierenden oder - aufnehmenden Stacks (zum Beispiel reflektierende Schichten, lichtstreuende Schichten)
- optimierte Schichten im Stack selbst.
Details sind in D. Hill: The optical outcoupling of organic light emitting Diodes, Dissertation an der TU Dresden, 2008, Seiten 30 bis 36, dargestellt.

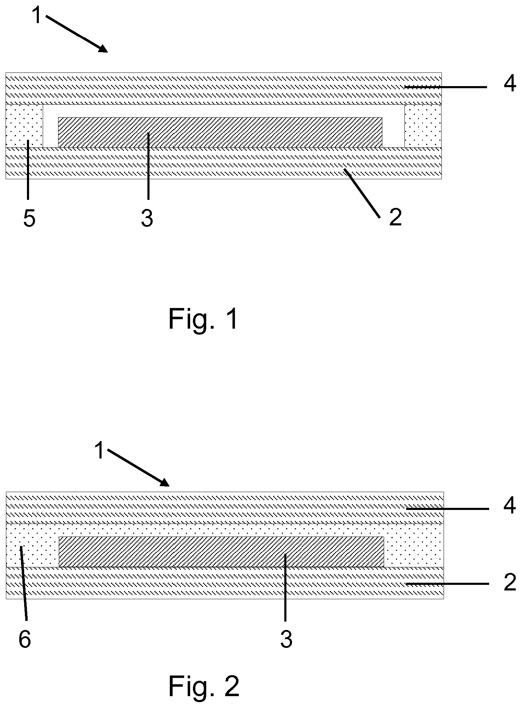

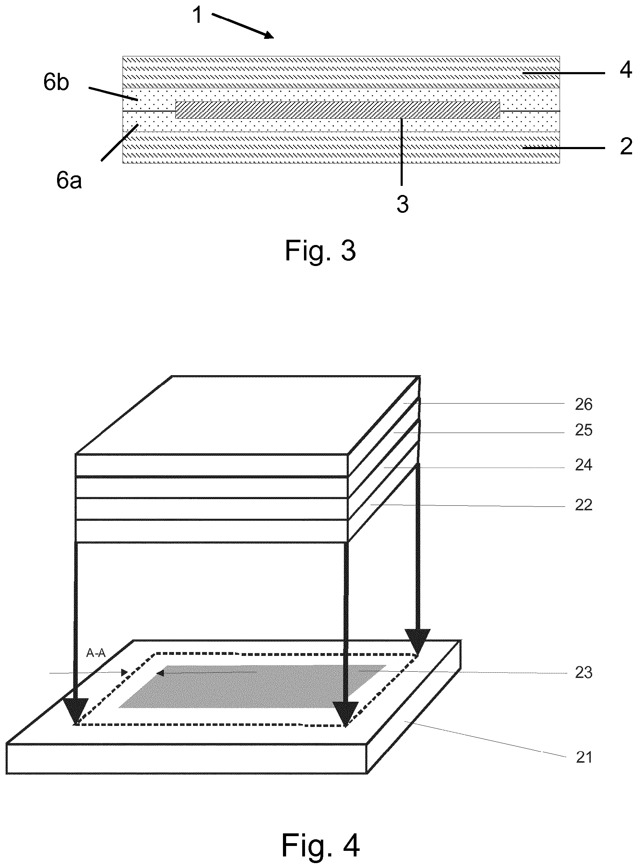

Eine weitere Maßnahme, insbesondere zur Homogenisierung des Lichtein- oder-ausfalls ist die vollflächige Verkapselung mit einem transluzenten Klebstoff. Vollflächig heißt dabei, dass die Klebstoffschicht die lichtemittierende oder -absorbierende Schicht im Wesentlichen überdeckt, wie es in den Figuren 2 und 3 dargestellt ist. Transluzent bedeutet, dass der Klebstoff eine ungerichtete Lichtstreuung in Transmission (Haze) von mehr als 10 % aufweist.

Die Lichtstreuung tritt in der Regel an einer in dem Klebstoff vorhandenen dispersen Phase auf. Naheliegend wäre es, die durch die im Stand der Technik bekannten, in der Regel anorganischen Gettermaterialpartikel erzeugte Streuung hier gezielt zu nutzen. Dies birgt jedoch den Nachteil, dass aufgrund ihrer Härte sowie Abrasivität von üblichen anorganischen Gettermaterialien (zum Beispiel Zeolith, Silika, Aluminiumoxid) an der Grenzfläche befindliche Partikel den elektronischen Aufbau beim Aufbringen des Klebstoffs, insbesondere beim Laminieren eines Klebebands, beschädigen können. Weiterhin weisen viele anorganische Gettermaterialien keine Transparenz auf, absorbieren selbst also auch Licht, was die Effizienz der optoelektronischen Anordnung mindert. Dies ist zum Beispiel bei Zeolith, Calciumoxid oder Aluminiumoxid der Fall. Die Lichtabsorption durch die Partikel ist oft auch wellenlängenabhängig, so dass eine unerwünschte Einfärbung des Klebstoffs erhalten wird.

Anorganische Materialien sind dazu oft wasserliebend, so wie die genannten Gettermaterialien. Damit erhöhen sie die Wasserdampfpermetionsrate des Klebstoffs, insbesondere, wenn sie keine wasseraufnehmenden Eigenschaften besitzen oder die Aufnahmekapazität ausgeschöpft ist.

Lichtstreuende Klebstoffe sind im Stand der Technik bekannt. So beschreibt WO 2010/033558 A1 eine Acrylat-Haftklebemasse, in die bevorzugt lichtreuende Partikel eingebracht werden. Diese werden ausgewählt aus der Gesamtheit der möglichen lichtstreuenden Partikel mit einem Brechungsindex von 1,3 bis 1,6, wobei dieser höher oder niedriger als der der Klebemasse sein kann. Bevorzugt werden Partikel aus Polymethylmethacrylat (PMMA, n=1,49) in einem hohen Anteil von bis zu 75 Gew.-% eingebracht. Eine Lehre, Partikel innerhalb eines definierten Brechungsindexbereichs auszuwählen, wird nicht gegeben.

In EP 2 510 066 A1 werden ebenfalls lichtstreuende Klebstoffe offenbart, bei denen bevorzugt PMMA-Partikel als Streuzentren verwendet werden. Es wird darüber hinaus gelehrt, dass Partikel mit einem höheren Brechungsindex als die Klebemasse vorteilhaft sind.

In JP 2008 310 267 A werden Silikon-Mikopartikel (n∼1,403) bevorzugt. Diese weisen eine hohe Wasserdampfpermeationsrate (größer 1000 g/m² d) auf, was für eine Verkapselungsanwendung nachteilig ist.

In der WO 2010 033 571 wird ein lichtstreuender Klebstoff umfassend eine Klebstoffmatrix enthaltend Silikonpartikel mit einem Durchmesser von 1-15 µm und in einer Menge von 0.5-25 Gew-% offenbart. Die Klebemasse weist einen höheren Brechungsindex als die Partikel auf.

Es besteht somit ein anhaltender Bedarf an einer Lösung, die eine insbesondere organische optoelektronische Anordnung zuverlässig vor dem Einfluss von Permeaten schützt und eine ausreichende Transluzenz aufweist.

Aufgabe der Erfindung ist es daher, eine Klebemasse anzubieten, die zur Reduzierung der Nachteile des Standes der Technik beitragen kann, die insbesondere eine Lichtstreuung der Klebemasse bei möglichst geringer Beeinträchtigung der Lichttransmission bereitstellt. Auch die Lebensdauer einer mit der Klebemasse verkapselten organischen elektronischen Anordnung soll möglichst nicht beeinträchtigt werden, sondern sie soll weiterhin insbesondere lange abdichtende Wirkung im genannten Einsatzgebiet besitzen. Vorteilhaft sollten die - insbesondere klebtechnischen - Eigenschaften des Klebebandes durch eine entsprechende Modifikation der Klebemasse nicht wesentlich nachteilig verändert werden.

Die erste Aufgabe wird gelöst durch einen transluzenten mehrphasigen Klebstoff enthaltend zumindest eine kontinuierliche Phase sowie dispers verteilte Domänen, wobei die zumindest eine kontinuierliche Phase eine Klebemasse auf der Basis von Styrolblockcopolymer, Polybutylen oder Polyolefin ist und
- einen Brechungsindex, wie im Prüfmethodenteil der Beschreibung bestimmt, von mehr als 1,45 und
- eine Permeationsrate für Wasserdampf, wie im Prüfmethodenteil der Beschreibung bestimmt, wobei der Wert auf eine Dicke der Klebemasse von 50 µm normiert ist, von weniger als 100 g/m²d aufweist, und die dispersen Domänen
- mit ihrem mittleren Durchmesser in einem Größenbereich von 0,1 µm bis 50 µm vorliegen sowie
- in einem Gewichtsanteil von nicht mehr als 10 Gew.-% in der Klebemasse enthalten sind,
- gekennzeichnet dadurch, dass die dispersen Domänen polymerer Natur sind, einen Brechungsindex, wie im Prüfmethodenteil der Beschreibung bestimmt, von weniger als 1,45 aufweisen und eine Wasserdampfpermeationsrate (WVTR), wie im Prüfmethodenteil der Beschreibung bestimmt, wobei der Wert auf eine Dicke von 50 µm normiert ist, von weniger als 100 g/m² d aufweisen

Die zweite Aufgabe wird gelöst , indem die Verkapselung der empfindlichen, auf einem Substrat befindlichen organischen optoelektronischen Anordnung mittels einer Abdeckung geschieht, die mittels eines transluzenten, insbesondere weitgehend permeatfreien Klebebandes fixiert wird, umfassend zumindest eine Schicht eines erfindungsgemäßen Klebstoffs.

Dementsprechend betrifft die Erfindung einen transluzenten mehrphasigen Klebstoff mit zumindest einer kontinuierlichen Phase (Matrix) sowie dispers verteilten polymeren Domänen. Dabei weist die kontinuierliche Phase, welche im Folgenden auch Klebemasse genannt wird, sofern sie selbst klebende Eigenschaften aufweist, einen Brechungsindex von mehr als 1,45 auf, und ist eine Klebemasse auf der Basis von Styrolblockcopolymer, Polybutylen oder Polyolefin. Der mittlere Durchmesser (d50) der polymeren dispersen Domänen liegt erfindungsgemäß in einem Größenbereich zwischen 0,1 µm und 50 µm. Die untere Grenze ist so gewählt, dass Licht noch maßgeblich gestreut wird. Die obere Grenze ist so gewählt, dass sich Schichtdicken im üblichen Klebebanddickenbereich noch einfach herstellen lassen, ohne zum Beispiel durch die Größe der Domänen das Risiko von Beschichtungsfehlern zu erhöhen. Der Gewichtsanteil der dispers verteilten polymeren Domänen in dem Klebstoff beträgt nicht mehr als 10 Gew.-%, um die Klebeigenschaften und Permeationsbarriere nicht wesentlich zu beeinträchtigen. Der erfindungsgemäße Klebstoff ist dadurch gekennzeichnet, dass die dispersen polymeren Domänen einen Brechungsindex von weniger als 1,45 aufweisen.
Sowohl die kontinuierliche Phase wie auch die polymeren dispersen Domänen weisen eine Permeationsrate für Wasserdampf (WVTR), wie im Prüfmethodenteil der Beschreibung bestimmt, wobei der Wert auf eine Dicke von 50 µm normiert ist, von weniger als 100 g/m²d auf.

Überraschend zeigte sich, dass bei der Wahl von dispersen polymeren Domänen mit, einem Brechungsindex von weniger als 1,45 und einer WVTR von weniger als 100 g/m²d bereits bei einem sehr geringem Gewichtsanteil der Domänen eine hohe Lichtstreuung erreicht wird. Dadurch werden die Transparenz, die Klebkraft wie auch die Barriereeigenschaften des Klebstoffs nicht oder nur gering beeinträchtigt.

Ein weiterer Aspekt der Erfindung betrifft ein Verfahren zum Schutz einer auf einem Substrat angeordneten organischen elektrischen Anordnung, wobei eine Abdeckung derart auf die elektronische Anordnung aufgebracht wird, dass die elektronische Anordnung zumindest teilweise durch die Abdeckung überdeckt wird, wobei weiterhin die Abdeckung zumindest teilflächig auf dem Substrat und/oder auf der elektronischen Anordnung verklebt wird, wobei die Verklebung mittels zumindest einer Schicht eines Klebstoffs bewirkt wird. Die Klebstoffschicht liegt dabei insbesondere als Schicht eines Klebebandes vor. Das Verfahren ist erfindungsgemäß dadurch gekennzeichnet, dass der Klebstoff ein erfindungsgemäßer mehrphasiger Klebstoff enthaltend eine kontinuierliche Phase sowie dispers verteilte polymere Domänen ist, wobei die kontinuierliche Phase eine Klebemasse auf der Basis von Styrolblockcopolymer, Polybutylen oder Polyolefin ist und einen Brechungsindex, wie im Prüfmethodenteil der Beschreibung bestimmt, von mehr als 1,45 und eine Permeationsrate für Wasserdampf, wie im Prüfmethodenteil der Beschreibung bestimmt, wobei der Wert auf eine Dicke der Klebemasse von 50 µm normiert ist, von weniger als 100 g/m²d aufweist, und die dispersen Domänen in einem Größenbereich von 0,1 µm bis 50 µm vorliegen sowie in einem Gewichtsanteil von nicht mehr als 10 Gew.-% in dem Klebstoff enthalten sind, gekennzeichnet dadurch, dass die dispersen polymeren Domänen einen Brechungsindex von weniger als 1,45 sowie eine WVTR von weniger als 100 g/m²d aufweisen. Insbesondere wird eine solche Klebemasse als kontinuierliche Phase eingesetzt, die bereits inhärent eine geringe Permeatdurchlässigkeit besitzt (im Folgenden als Klebemasse mit inhärenter Barrierewirkung bezeichnet). Besonders bevorzugt weist die Klebemasse bei einer Dicke von 50 µm eine Wasserdampfpermeationsrate von weniger als 50 g/(m²·d) und/oder eine Sauerstoffdurchtrittsrate von weniger als 5000 g/(m²·d·bar) auf.

Besonders bevorzugt weisen die polymeren Domänen eine Wasserdampfpermeationsrate von weniger als 50 g/(m²·d) und/oder eine Sauerstoffdurchtrittsrate von weniger als 5000 g/(m²·d·bar) auf, ermittelt an einer Schicht des Polymers mit einer Dicke von 50 µm.

Die Unteransprüche betreffen vorteilhafte Ausführungen des Klebstoffs und des Verfahrens.
Gegenstand der Erfindung ist zudem ein Klebeband, umfassend eine Schicht eines Klebstoffs, wobei der Klebstoff ein erfindungsgemäßer mehrphasiger Klebstoff enthaltend eine kontinuierliche Phase sowie dispers verteilte polymere Domänen ist, wobei die
kontinuierliche Phase eine Klebemasse auf der Basis von Styrolblockcopolymer, Polybutylen oder Polyolefin ist und einen Brechungsindex, wie im Prüfmethodenteil der Beschreibung bestimmt, von mehr als 1,45 und eine Permeationsrate für Wasserdampf, wie im Prüfmethodenteil der Beschreibung bestimmt, wobei der Wert auf eine Dicke der Klebemasse von 50 µm normiert ist, von weniger als 100 g/m²d aufweist und die dispersen Domänen in einem Größenbereich von 0,1 µm bis 50 µm vorliegen sowie in einem Gewichtsanteil von nicht mehr als 10 Gew.-% in dem Klebstoff enthalten sind, gekennzeichnet dadurch, dass die dispersen polymeren Domänen einen Brechungsindex von weniger als 1,45 sowie eine WVTR von weniger als 100 g/m²d aufweisen.

Unter einem transluzenten Klebstoff wird ein lichtstreuender Klebstoff mit einer Lichttransmission von mehr als 70 % und einem Haze von mehr als 10 % verstanden. Die Transmission und der Haze des Klebstoffs werden analog ASTM D1003-11 (Procedure A (Hazemeter Byk Haze-gard Dual), Normlichtart D65) an einer 50 µm dicken Schicht des Klebstoffs bestimmt. Eine Korrektur von Grenzflächenreflextionsverlusten wird nicht vorgenommen.

Der mehrphasige Klebstoff umfasst zumindest eine kontinuierliche Phase und eine disperse Phase. Weitere Phasen können enthalten sein, zum Beispiel eine weitere kontinuierliche Phase, so dass sich eine kokontinuierliche Phasenstruktur ergibt, in der eine oder beide Phasen die disperse Phase enthalten können. Aber auch weitere disperse Phasen können enthalten sein, solange die Transparenz gegeben bleibt. Dies ist zum Beispiel oft der Fall, wenn die weitere disperse Phase nanopartikulär ist, also eine mittlere Partikelgröße von weniger als 100 nm aufweist.

Die disperse Phase ist ein Polymer. Ein Polymer ist eine chemische Verbindung, die aus Ketten- oder verzweigten Molekülen (Makromolekül) besteht, die aus gleichen, gleichartigen oder verschiedenen Einheiten (den sogenannten Monomeren) bestehen. Im einfachsten Fall besteht das Makromolekül nur aus einer Monomerart. Copolymere sind aus verschiedenen Monomeren aufgebaut,. die im Makromolekül statistisch verteilt, regelmäßig verteilt oder in Blöcken vorliegen können. Polymere enthalten mindestens drei gleiche Monomereinheiten. Eine Monomereinheit im Sinne dieser Begriffsbestimmung ist die gebundene Form eines Monomers in einem Polymer. Die disperse Phase kann auch als Mischung zweier oder mehrerer Polymere vorliegen. Die Mischung kann eine Mischung verschiedenartiger disperser Phasen in der kontinuierlichen Phase sein oder aber einen Mischung verschiedenen Polymere in einem einzelnen Volumenelement der dispersen Phase. Die Mischung innerhalb eines Volumenelements kann homogen sein oder auch als Struktur, wie zum Beispiel als Schichtstruktur in einem Core-Shell-Partikel, vorliegen. Es können auch weitere Stoffe enthalten sein, die kein Polymer sind, wobei deren Anteil dann weniger als 50 Gew.-% beträgt. Bevorzugt ist die disperse Phase ein Polymer oder eine Mischung zweier oder mehrerer Polymere.

Die disperse Phase kann in festem oder flüssigem Aggregatzustand vorliegen. So können auch flüssige Polymere in der Klebemasse dispergiert werden, sofern ihr Brechungsindex erfindungsgemäß kleiner als 1,45 sowie ihre WVTR kleiner als 100 g/m²d ist. Bevorzugt ist das Vorliegen als feste Phase, da zum Beispiel die Gefahr von Migration der dispersen Phase geringer ist.

Bevorzugt unterscheiden sich die Brechungsindices der kontinuierlichen Phase und der dispersen Domänen um mehr als den Wert von 0,8.

Die polymeren dispersen Domänen haben einen Brechungsindex von weniger als 1,45. Bevorzugt haben die Domänen einen Brechungsindex von weniger als 1,41, insbesondere bevorzugt einen Brechungsindex von weniger als 1,37. Je geringer der Brechungsindex ist, desto größer ist die Lichtstreuung bereits bei geringem Gewichtsanteil. Die Einsatzmenge kann also vorteilhaft vermindert werden. Der Brechungsindex wird nach ISO 489 (Methode A, Messwellenlänge 589 nm) bei einer Temperatur von 20 °C und einer relativen Luftfeuchte von 50 % bestimmt.

Bevorzugt wird die polymere Domäne ausgewählt aus der Gruppe der Polymere, wie sie in Tabelle 1 aufgelistet ist:

| **Abbr.** | Polymer | Brechungsindex |
|---|---|---|
| PHFPO | Poly(hexafluoropropylene oxide) | 1,301 |
| | Poly(tetrafluoroethylene-co-hexafluoropropylene) | 1,338 |
| FEP | Fluorinated Ethylene Propylene | 1,338 |
| | Poly(pentadecafluorooctyl acrylate) | 1,339 |
| | Poly(tetrafluoro-3-(heptafluoropropoxy)propyl acrylate) | 1,346 |
| | Poly(tetrafluoro-3-(pentafluoroethoxy)propyl acrylate) | 1,348 |
| PTFE | Poly(tetrafluoroethylene) | 1,35 |
| THV | Tetrafluoroethylene hexafluoropropylene vinylidene fluoride | 1,35 |
| | Poly(undecafluorohexyl acrylate) | 1,356 |
| PFA | Perfluoroalkoxy | 1,34 |
| ETFE | Ethylene Tetrafluoroethylene | 1,4 |
| | Poly(nonafluoropentyl acrylate) | 1,36 |
| | Poly(tetrafluoro-3-(trifluoromethoxy)propyl acrylate) | 1,36 |
| | Poly(pentafluorovinyl propionate) | 1,364 |
| | Poly(heptafluorobutyl acrylate) | 1,367 |
| | Poly(trifluorovinyl acetate) | 1,375 |
| | Poly(octafluoropentyl acrylate) | 1,38 |
| | Poly(methyl 3,3,3-trifluoropropyl siloxane) | 1,383 |
| | Poly(pentafluoropropyl acrylate) | 1,385 |
| | Poly(2-heptafluorobutoxy)ethyl acrylate) | 1,39 |
| PCTFE | Poly(chlorotrifluoroethylene) | 1,39 |
| | Poly(2,2,3,4,4-hexafluorobutyl acrylate) | 1,392 |
| | Poly(trifluoroethyl acrylate) | 1,407 |
| | Poly (2-(1,1,2,2-tetrafluoroethoxy)ethyl acrylate) | 1,412 |
| | Poly(trifluoroisopropyl methacrylate) | 1,4177 |
| | Poly(2,2,2-trifluoro-1-methylethyl methacrylate) | 1,4185 |
| | Poly(2-trifluoroethoxyethyl acrylate) | 1,419 |
| PVDF | Poly(vinylidene fluoride) | 1,42 |
| ECTFE | Ethylene Chlorotrifluroethylene | 1,447 |
| | Poly(trifluoroethyl methacrylate) | 1,437 |
| | Poly(isobutyl methacrylate) | 1,447 |

| | | |
|---|---|---|
| Quelle: TexLoc Refractive Index of Polymers, Firmenschrift Parker Hannnifin Corporation, Fort Worth, USA, 2007, http://www.texloc.com/closet/cl_refractiveindex.html Auch Copolymere der genannten Polymere sind umfasst. | | |

Besonders bevorzugt enthält das Polymer der polymeren Domäne Fluor. Fluorpolymere weisen bei niedrigem Brechungsindex eine geringe Wasserdampfpermeation auf und somit ist die Beeinträchtigung der Wasserdampfpermeation des Klebstoffs nur gering. Im Gegensatz dazu weisen zum Beispiel reine Acrylate und Silikone eine höhere Wasserdampfpermeation als 100 g/m² d auf, beeinträchtigen die Barriereeigenschaften des Klebstoffs damit stärker und sind somit nicht für die Lösung der Aufgabe geeignet.

Weiter bevorzugt ist das Polymer ausgewählt aus der Gruppe Poly(hexafluoropropylene oxide)(PHFPO), Fluorinated Ethylene Propylene Polymer(FEP), Poly(tetrafluoroethylene) (PTFE), Poly(Tetrafluoroethylene hexafluoropropylene vinylidene fluoride) (THV) Perfluoroalkoxy Polymer (PFA), Polyethylene Tetrafluoroethylene) (ETFE), Poly(Chlorotrifluoroethylene) (PCTFE), Poly(Vinylidene Fluoride) (PVDF) und Poly (Ethylene Chlorotrifluroethylene) (ECTFE)sowie deren Co- und Terpolymere, da diese Polymere kommerziell leicht erhältlich sind.

Das Polymer der dispersen Phase weist eine Wasserdampfpermeationsrate von weniger als 100 g/m²d, bevorzugt unterhalb von 50 g/m²d, auf. Besonders geeignete Polymere sind zum Beispiel (Tabelle 2):

| Polymer | WVTR (40 °C/95% rF, 50 µm) |
|---|---|
| PVF | 30 |
| ETFE | 12 |
| PVDC | 6 |
| PVdF | 4 |
| PFA | 4 |
| FEP | 2 |
| PCTFE | 0,2 |
| PTFE | < 10 |

In einer weiteren bevorzugten Ausführung liegen die polymeren Domänen als fluorhaltige mikrokristalline Wachse vor. Solche Wachse werden zum Beispiel unter dem Handelsnamen Ceridust F von der Firma Clariant, Gersthofen, oder Ceraflour von der Firma Byk, Wesel, angeboten.

Unter dem Begriff "Wachs" werden nach Habenicht (a.a.O.) verschiedene Produkte verstanden, die pflanzlichen, tierischen oder geologischen Ursprungs sind und die hinsichtlich ihrer chemischen Basis im Wesentlichen aus Kohlenwasserstoffen, höheren Alkoholen, Säuren und Estern bestehen. Unabhängig von der chemischen Zusammensetzung bestimmen die physikalischen Eigenschaften wie Schmelzpunkt, Löslichkeit, Inertheit etc. die Einstufung eines Wachses. Die wesentlichen Kriterien sind:
- ein Schmelzpunkt von wenigstens 40 °C,
- verhältnismäßig niedrige Schmelzviskosität und nicht fadenziehend im Gegensatz zu vielen Harzen,
- zunehmende Löslichkeit und keine chemische Zersetzung bei erhöhter Temperatur.

Die lichtstreuenden polymeren Domänen liegen in einem Anteil von weniger als 10 Gew.-% im erfindungsgemäßen Klebstoff vor. Je geringer der Anteil ist, desto weniger beeinträchtigen die Domänen die Barriereeigenschaften der Klebemasse. Der Anteil kann je nach Brechungsindex der Domänen gewählt werden:
Ist der Brechungsindex der Domänen niedrig, also etwa unterhalb von 1,40, liegt der bevorzugte Anteil zwischen 1 und 5 Gew.-%, um eine für viele Anwendungen ausreichende Lichtstreuung zu erreichen. Ist der Brechungsindex der Domänen näher bei 1,45, liegt der bevorzugte Anteil zwischen 5 und 10 Gew.-%,
Für eine hohe Lichtstreuung wird bevorzugt ein niedriger Brechungsindex mit einem hohen Anteil kombiniert, als etwa ein Brechungsindex von weniger als 1,40 mit einem Anteil von 5 % bis 10 %.

Möglich ist auch ein Anteil von mehr als 10 Gew.-%, also etwa bis 20 Gew.-%, um eine besonders hohe Streuwirkung zu erreichen. Dabei nimmt allerdings die Transmission deutlicher ab.

Als untere Grenze für eine technische Anwendbarkeit wird insbesondere ein Anteil der Domänen von 1 Gew.-% angesehen.

Der mehrphasige Klebstoff kann mit allen dem Fachmann bekannten Verfahren hergestellt werden, also etwa durch Mischen, Dispergieren, Emulgieren, Ausfällen oder Separation der Phasen aus einer homogenen Phase, wie dies zum Beispiel bei der Phasenseparation von Blockcopolymeren oder der Schlagzähmodifizierung von Epoxidharzen bekannt ist. Die kontinuierliche Phase und die disperse Phase können durch allenfalls schwache Wechselwirkungen miteinander verknüpft nebeneinander vorliegen oder auch chemisch kovalent oder ionisch miteinander verbunden vorliegen.

Bevorzugt besteht der Klebstoff aus einer kontinuierlichen Klebemassephase und einem als dispergierte Phase verteilten partikulären Füllstoff.

Unter "als dispergierte Phase verteilt" wird verstanden, dass der Füllstoff fein verteilt in der Klebemasse vorliegt. Grundsätzlich sind Form und Größe der Füllstoffteilchen - selbstverständlich innerhalb der sich aus dem Aufbau und der Funktion der Klebemasse ergebenden Limitierungen - keine Grenzen gesetzt. Das Merkmal "als dispergierte Phase verteilt" schließt eine Dispersion von Füllstoff-Primärteilchen, Füllstoff-Aggregaten und Füllstoff-Agglomeraten mit ein, wobei Primärteilchen bevorzugt sind, da mehr Grenzfläche zur Lichtstreuung zur Verfügung steht und solche Füllstoffe wirksamer sind.

Das Merkmal "als dispergierte Phase verteilt" bedeutet darüber hinaus, dass der Füllstoff keine eigenständige, durchgehende Schicht bildet, sondern generell in Form mehrerer, verteilter Teilchen vorliegt. Es bedeutet hingegen nicht, dass eine ideale oder statistische Verteilung der Füllstoffteilchen in der Klebemasse vorliegen muss. Die Füllstoffteilchen können sich zum Beispiel durchaus in bestimmten Bereichen innerhalb der Klebemasse konzentrieren beziehungsweise können bestimmte Bereiche einer Klebstoffschicht auch frei von Füllstoff sein.

Grundsätzlich ist die Größe der Partikel des Füllstoffs durch die Anforderungen an den Klebstoff, insbesondere der Dicke der in der Anwendung oder im Klebeband den Klebstoff enthaltenden Schicht begrenzt. Als eine obere Grenze für die mittlere Größe der Partikel können daher etwa 50 µm angesehen werden, bevorzugt wird aber Gettermaterial in Form von Teilchen mit einer mittleren Größe von maximal 20 µm, besonders bevorzugt maximal 10 µm verwendet.

Als untere Grenze wird einen mittlere Größe von 0,1 µm gesehen, da darunter im wesentlichen Raleigh-Streuung auftritt, die aufgrund ihrer Wellenlängenabhängigkeit zu einer Verfärbung des transmittierten Lichts führen kann. Bevorzugt liegt die untere Grenze im Bereich der Wellenlänge des sichtbaren Lichts, also bei 0,4 µm, da in diesem Bereich die Lichtstreuung besonders effizient ist.

Unter "mittlere (Partikel)Größe" wird die mittlere maximale Ausdehnung einer dispersen Domäne verstanden. Die Bestimmung der Partikelgröße erfolgt bevorzugt mittels Laserbeugung nach ISO 13320 (wobei im Dispersionsschritt Agglomerate dispergiert werden, nicht jedoch Aggregate), aber auch andere dem Fachmann bekannte Verfahren sind geeignet. Die mittlere Größe ist diejenige, bei der die Hälfte des Volumens der enthaltenen Domänen beziehungsweise Partikel eine maximale Ausdehnung unterhalb oder gleich dieser Größe aufweist (d50).

Vorzugsweise liegt der Füllstoff in Form von Partikeln in einer Partikelgrößenverteilung vor, bei der maximal 1 Vol.-% des Füllstoffs die mittlere Schichtdicke der Klebstoffschicht überschreitet. Dies hat den Vorteil, dass die Partikel nicht aus der jeweiligen Schicht herausragen und damit die Oberflächeneigenschaften stark negativ beeinflussen.

Als kontinuierliche Phase kann prinzipiell jede im Stand der Technik beschriebene (zum Beispiel in G. Habenicht: Kleben, 6. Auflage, Springer 2009) Klebemasse mit einer WVTR von weniger als 100g/m²d verwendet werden, erfindungsgemäß ist die kontinuierliche Phase jedoch eine Klebemasse auf der Basis von Styrolblockcopolymer, Polybutylen oder Polyolefin.

Sehr vorteilhaft ist die Klebemasse des erfindungsgemäßen Klebstoffs und die Klebemasse des im erfindungsgemäßen Verfahren eingesetzten Klebebandes eine Haftklebemasse, in einer weiteren bevorzugten Ausführungsvariante eine aktivierbare Klebemasse. Besonders bevorzugt werden aktivierbare Haftklebemassen eingesetzt.

Als Haftklebemassen werden Klebemassen bezeichnet, deren abgebundener Film bei Raumtemperatur in trockenem Zustand permanent klebrig und klebfähig bleibt. Haftklebemassen erlauben bereits unter relativ schwachem Andruck eine dauerhafte Verbindung mit dem Haftgrund und können nach Gebrauch im Wesentlichen rückstandsfrei vom Haftgrund wieder abgelöst werden. Die Verklebbarkeit der Klebemassen beruht auf ihren adhäsiven Eigenschaften und die Wiederablösbarkeit auf ihren kohäsiven Eigenschaften.
Als aktivierbare Klebemassen werden Klebemassensysteme angesehen, bei denen die Verklebung durch einen Energieeintrag, zum Beispiel durch aktinische Strahlung oder Wärme, erfolgt.

Im Folgenden wird die Bezeichnung "(Haft-)Klebemasse" im Sinne von "Klebemasse, insbesondere in der Ausführungsform als Haftklebemasse" verwendet. Entsprechend bedeutet die Bezeichnung "(Haft-)Klebeband" "Klebeband, insbesondere in der Ausführung als Haftklebeband". Ohne weiteres sollen die jeweils aktivierbaren Varianten explizit mit umfasst sein. Sofern lediglich von "Klebemasse" oder "Klebeband" die Rede ist, soll die Ausführungsform als "Haftklebeband" bzw. "Haftklebemasse" und die Ausführungsform als aktivierbare Klebemasse, auch in Kombination miteinander (aktivierbare Haftklebemasse), jedoch explizit umfasst sein, sofern im Einzelnen nichts anderes angegeben ist.

Eine weitere vorteilhafte Ausführung der Erfindung betrifft ein transluzentes Klebeband umfassend zumindest eine Schicht eines erfindungsgemäßen Klebstoffs.

In bevorzugter Vorgehensweise wird ein Klebeband, insbesondere ein Haftklebeband, eingesetzt, das in Form einer einzigen Schicht des entsprechenden (Haft-)Klebstoffs eingesetzt wird. Solche einschichtigen Klebebänder werden als "Transferklebebänder" bezeichnet und zur leichteren Handhabbarkeit häufig ein- oder doppelseitig mit einem temporären Träger angeboten, der für die Anwendung wieder entfernt wird. Als temporäre Träger sind beispielweise antiadhäsive Folien und Papiere geeignet, etwa silikonisierte Folien und Papiere.

Weiterhin kann das Transferklebeband über die Klebemasseschicht und gegebenenfalls eine Gettermaterialschicht hinaus aus weiteren Schichten bestehen. Dies können zum Beispiel weitere Klebemasseschichten, Trägermaterial oder Liner sein.

Bevorzugt ist eine solche weitere Schicht ein Trägermaterial, insbesondere ein polymeres Trägermaterial, da hierdurch die Stanzbarkeit oder Applizierbarkeit des Aufbaus verbessert wird.

Als Trägermaterial können textile Flächengebilde, Papiere, kunststoffbeschichtete Papiere oder Folien eingesetzt werden, wobei Folien, insbesondere dimensionsstabile Kunststoff- oder Metallfolien, bevorzugt werden. Eine Trägerschicht besteht daher bevorzugt aus Polyestern, insbesondere aus Polyethylenterephthalat, zum Beispiel aus biaxial verstrecktem Polyethylenterephthalat, oder aus Polyolefinen, insbesondere aus Polybuten, Cyclo-Olefin-Copolymer, Polymethylpenten, Polypropylen oder Polyethylen, zum Beispiel aus monoaxial verstrecktem Polypropylen, biaxial verstrecktem Polypropylen oder biaxial verstrecktem Polyethylen. Polyesterfolien weisen den Vorteil auf, dass sie für Temperaturstabilität sorgen und eine erhöhte mechanische Stabilität einbringen. Ganz besonders bevorzugt besteht daher eine Trägerschicht in einem erfindungsgemäßen Liner aus einer Polyesterfolie, beispielsweise aus biaxial verstrecktem Polyethylenterephthalat.

In einer bevorzugten Ausführungsform enthält das Trägermaterial auch eine Barrierefunktion gegen ein oder mehrere spezifische(s) Permeat(e), insbesondere gegen Wasserdampf und Sauerstoff. Eine derartige Barrierefunktion kann aus organischen oder anorganischen Materialien bestehen. Trägermaterialien mit Barrierefunktion sind in EP 2 078 608 A1 ausführlich dargestellt.

Besonders bevorzugt enthält das Trägermaterial mindestens eine anorganische Barriereschicht. Als anorganische Barriereschichten eignen sich besonders gut im Vakuum (zum Beispiel mittels Verdampfen, CVD, PVD, PECVD) oder unter Atmosphärendruck (zum Beispiel mittels Atmosphärenplasma, reaktiver Coronaentladung oder Flammenpyrolyse) abgeschiedene Metalle, wie Aluminium, Silber, Gold, Nickel oder insbesondere Metallverbindungen wie Metalloxide, -nitride oder -hydronitride, beispielsweise Oxide oder Nitride des Siliziums, des Bors, des Aluminiums, des Zirkoniums, des Hafniums oder des Tellurs oder Indium-Zinn-Oxid (ITO). Ebenfalls geeignet sind mit weiteren Elementen dotierte Schichten der vorstehend genannten Varianten.

Als besonders geeignetes Verfahren zum Aufbringen einer anorganischen Barriereschicht sind High-Power-Impulse-Magnetron-Sputtering und Atomic-Layer-Deposition zu nennen, durch die sich besonders permeationsdichte Schichten bei geringer Temperaturbelastung der Trägerschicht verwirklichen lassen. Bevorzugt wird eine Permeationsbarriere der Trägerschicht mit Barrierefunktion beziehungsweise des Verbundes aus Trägerschicht und Barriereschicht gegen Wasserdampf (WVTR) von < 1 g/(m²*d) und/oder gegen Sauerstoff (OTR) von < 1 cm³/(m²*d*bar), wobei der Wert auf die jeweils im Flächengebilde verwendete Dicke der Trägerschicht bezogen ist, also nicht auf eine spezifische Dicke normiert ist. Die WVTR wird dabei bei 38 °C und 90 % relativer Luftfeuchtigkeit nach ASTM F-1249 und die OTR bei 23 °C und 50 % relativer Luftfeuchtigkeit nach DIN 53380-Teil 3 gemessen.
Ist das Trägermaterial wie vorstehend beschrieben mit einer Barrierefunktion ausgerüstet, kann es auch als Abdeckung im erfindungsgemäßen Verfahren angesehen werden. In diesem Fall wird die Klebemasse zunächst auf die Abdeckung aufgebracht.

Klebebänder, die ein- oder beidseitig mit Klebstoffen beschichtet sind, werden am Ende des Herstellungsprozesses zumeist zu einer Rolle in Form einer archimedischen Spirale aufgewickelt. Um bei doppelseitig klebenden Klebebändern zu verhindern, dass die Klebemassen miteinander in Kontakt kommen, oder um bei einseitig klebenden Klebebändern eine Verklebung der Klebemasse auf dem Träger zu verhindern, werden die Klebebänder vor dem Wickeln mit einem Abdeckmaterial (auch als Trennmaterial bezeichnet) eingedeckt, das zusammen mit dem Klebeband aufgewickelt wird. Dem Fachmann sind derartige Abdeckmaterialien unter den Namen Liner oder Releaseliner bekannt. Neben der Abdeckung von ein- oder doppelseitig klebenden Klebebändern werden Liner auch zur Eindeckung von reinen Klebemassen (Transferklebeband) und Klebebandabschnitten (zum Beispiel Etiketten) eingesetzt.

Ein weiterer Hauptanspruch betrifft ein Verfahren zum Schutz einer auf einem Substrat angeordneten organischen elektrischen Anordnung, wobei eine Abdeckung derart auf die elektronische Anordnung aufgebracht wird, dass die elektronische Anordnung zumindest teilweise durch die Abdeckung überdeckt wird, wobei weiterhin die Abdeckung zumindest teilflächig auf dem Substrat und/oder auf der elektronischen Anordnung verklebt wird, wobei die Verklebung mittels zumindest einer Schicht eines Klebemassestoffs bewirkt wird. Die Klebstoffschicht liegt dabei insbesondere als Schicht eines Klebebandes vor. Das Verfahren ist erfindungsgemäß dadurch gekennzeichnet, dass der Klebemassestoff ein erfindungsgemäßer mehrphasiger Klebstoff enthaltend eine kontinuierliche Phase sowie dispers verteilte polymere Domänen ist, wobei die kontinuierliche Phase einen Brechungsindex, wie im Prüfmethodenteil der Beschreibung bestimmt, von mehr als 1,45 sowie eine WVTR von weniger als 100 g/m²d aufweist, und die dispersen Domänen in einem Größenbereich von 0,1 µm bis 50 µm vorliegen sowie in einem Gewichtsanteil von nicht mehr als 10 Gew.-% in dem Klebstoff enthalten sind, gekennzeichnet dadurch, dass die dispersen polymeren Domänen einen Brechungsindex von weniger als 1,45 sowie eine WVTR von weniger als 100 g/m²d aufweisen.

Das erfindungsgemäße Verfahren kann vorteilhaft derart geführt werden, dass zunächst die (Haft-)Klebstoffschicht, gegebenenfalls als Bestandteil eines weitere Schichten umfassenden doppelseitig klebenden Klebebandes, und in einem nachfolgenden Schritt die Abdeckung auf das Substrat und/oder die elektronische Anordnung aufgebracht wird. In einer weiteren vorteilhaften Vorgehensweise werden die (Haft-)Klebstoffschicht, gegebenenfalls als Bestandteil eines weitere Schichten umfassenden doppelseitig klebenden Klebebandes, und die Abdeckung gemeinsam auf das Substrat und/oder die elektronische Anordnung aufgebracht.
Beim erfindungsgemäßen Verfahren kann das Transferklebeband somit zunächst mit dem Substrat beziehungsweise der elektronischen Anordnung verbunden werden oder zuerst mit der Abdeckung. Bevorzugt ist jedoch, zunächst das Transferklebeband mit der Abdeckung zu verbinden, da somit eine Baugruppe der elektronischen Funktionseinheit unabhängig von der elektronischen Anordnung vorgefertigt und als Ganzes zulaminiert werden kann.

Vorteilhaft kann das erfindungsgemäße Verfahren derart geführt werden, dass die Abdeckung und/oder die (Haft-)Klebstoffschicht, insbesondere als Transferklebeband, die elektronische Anordnung vollständig überdecken, da dann die lichtstreuende Wirkung die gesamte Fläche der Anordnung betrifft..

Durch die vollflächige Lamination des Transferklebebands über die elektronische Anordnung wird zudem die Einwirkung möglicherweise im Gasraum einer lediglich randverkapselten Anordnung eingeschlossener schädlicher Permeate ausgeschlossen, da es keinen Gasraum gibt.

Das erfindungsgemäße Verfahren wird bevorzugt derart geführt, dass auch ein Bereich des Substrats um die elektronische Anordnung herum durch die Abdeckung ganz oder teilweise überdeckt wird, wobei das Klebeband zur Verklebung die elektronische Anordnung dabei vollflächig bedecken kann und bevorzugt ebenfalls einen Bereich des Substrats um die elektronische Anordnung herum bedeckt, bevorzugt denselben Bereich wie die Abdeckung - oder teilflächig aufgebracht sein kann, etwa rahmenförmig um die elektrische Anordnung herum - bevorzugt in dem Bereich, der auch durch die Abdeckung bedeckt wird -, und gegebenenfalls zusätzlich in einem Randbereich auf der elektronischen Anordnung.

Der erfindungsgemäße Klebstoff, das erfindungsgemäße (Haft-)Klebeband und das für das erfindungsgemäße Verfahren eingesetzte (Haft-)Klebeband können auch mindestens ein zur Sorption mindestens einer permeationsfähigen Substanz befähigtes Gettermaterial enthalten.

Vorteilhaft beträgt der Anteil des Gettermaterials in der (Haft-)Klebemasse nicht mehr als 10 Gew.-%, bevorzugt nicht mehr als 5 Gew.-%. Vorteilhaft beträgt der Anteil des Gettermaterials in der (Haft-)Klebemasse mindestens 0,01 Gew.-%, bevorzugt mindestens 0,05 Gew.-%.

Grundsätzlich ist die Größe der Partikel des Gettermaterials durch die Anforderungen der Dicke der diese enthaltenden Schicht, beispielsweise der Klebstoffschicht, begrenzt. Bevorzugt wird das Gettermaterial in Form von Teilchen mit einer Korngröße von maximal 50 µm, besonders bevorzugt in Form von Teilchen mit einer Korngröße von maximal 10 µm verwendet.

Vorzugsweise liegt das Gettermaterial in Form von Partikeln in einer Partikelgrößenverteilung vor, bei der maximal 1 Vol.-% des Gettermaterials die mittlere Schichtdicke der gettermaterialhaltigen Schicht überschreitet. Dies hat den Vorteil, dass die Getterpartikel nicht aus der jeweiligen Schicht herausragen und damit die Oberflächeneigenschaften stark negativ beeinflussen. In einer besonders bevorzugten Ausführungsform liegt das gesamte im erfindungsgemäßen Transferklebeband enthaltene Gettermaterial in einer Partikelgrößenverteilung vor, bei der maximal 1 Vol.-% des Gettermaterials die mittlere Schichtdicke der gettermaterialhaltigen Schicht überschreitet.

Besonders bevorzugt liegen alle Gettermaterialien nanoskalig vor, das heißt die maximale Ausdehnung in mindestens einer Dimension beträgt weniger als 500 nm, ganz besonders bevorzugt weniger als 200 nm, beispielsweise weniger als 100 nm. Nanoskalige Gettermaterialien beeinträchtigen die Transparenz weniger als größere Teilchen.

Solche Gettermaterialien können beispielsweise dispergiertes pyrogenes Silica wie Aerosil der Firma Evonik, Calcium Oxide Nanopowder der Firma Sigma-Aldrich, Calciumchlorid CA-CI-02-NP der Firma American Elements (Los Angeles), Nanozeolith LTA oder FAU der Firma Nanoscape (Planegg-Martinsried) oder nanoskaliges Zeolith Lucidot NCL 40 der Firma Clariant (Frankfurt) sein.

Unter "Sorption" wird der Vorgang der selektiven Aufnahme eines Stoffes oder mehrerer Stoffe durch einen anderen Stoff - erfindungsgemäß durch das Gettermaterial - verstanden. Die Sorption der permeationsfähigen Substanz(en) durch das Gettermaterial kann dabei beispielsweise durch Absorption oder Adsorption erfolgen, wobei Adsorption sowohl in Form von Chemisorption als auch von Physisorption auftreten kann.

Unter einer "permeationsfähigen Substanz" wird eine Substanz verstanden, die als gasförmiger oder flüssiger, gegebenenfalls auch als fester Stoff, in die zu schützende Klebemasse eindringen und diese nachfolgend durchdringen kann. Derartige Substanzen werden nachstehend - wie im vorliegenden Text schon mehrfach geschehen - als "Permeate" bezeichnet. Die Permeate können aus der Klebemasse selbst oder aus der Umgebung, beispielsweise auch aus dem Trägermaterial eines mit der Klebemasse beschichteten Klebebandes stammen. Aus der Klebemasse beziehungsweise aus dem Klebeband selbst kommen häufig niedermolekulare organische Verbindungen wie Lösemittelreste, Restmonomere, Öle, Harzkomponenten, Weichmacher sowie Wasser. Aus der Umgebung stammen oft Wasser, flüchtige organische Verbindungen (VOCs), niedermolekulare Kohlenwasserstoffe und Sauerstoff. Als "permeationsfähige Substanzen" werden insbesondere Wasserdampf und Sauerstoff angesehen:
Unter einem "Gettermaterial" wird ein Material verstanden, das - im Sinne des vorstehend als "Sorption" definierten Vorgangs - mindestens eine permeationsfähige Substanz selektiv oder nicht selektiv aufnehmen kann. Das Gettermaterial ließe sich daher auch als "Sorbens" oder als "Sorptionsmittel" bezeichnen. Vorzugsweise ist das Gettermaterial mindestens zur Sorption von Wasser befähigt.

Geeignete Gettermaterialien sind beispielsweise Salze wie Cobaltchlorid, Calciumchlorid, Calciumbromid, Lithiumchlorid, Lithiumbromid, Magnesiumchlorid, Bariumperchlorat, Magnesiumperchlorat, Zinkchlorid, Zinkbromid, Kieselsäuren (zum Beispiel Silica Gel), Aluminiumsulfat, Calciumsulfat, Kupfersulfat, Bariumsulfat, Magnesiumsulfat, Lithiumsulfat, Natriumsulfat, Cobaltsulfat, Titansulfat, Natriumdithionit, Natriumcarbonat, Natriumsulfat, Kaliumdisulfit, Kaliumcarbonat, Magnesiumcarbonat, Titandioxid, Kieselgur, Zeolithe, Schichtsilikate wie Montmorillonit und Bentonit, Metalloxide wie Bariumoxid, Calciumoxid, Eisenoxid, Magnesiumoxid, Natriumoxid, Kaliumoxid,Strontiumoxid, Aluminiumoxid (aktiviertes Alumina); weiter Kohlenstoffnanoröhrchen, Aktivkohle, Phosphorpentoxid und Silane; leicht oxidierbare Metalle wie beispielsweise Eisen, Calcium, Natrium und Magnesium; Metallhydride wie beispielsweise Calciumhydrid, Bariumhydrid, Strontiumhydrid, Natriumhydrid und Lithiumaluminiumhydrid; Hydroxide wie Kaliumhydroxid und Natriumhydroxid, Metallkomplexe wie zum Beispiel Aluminiumacetylacetonat; des Weiteren organische Absorber, beispielsweise Polyolefin-Copolymere, Polyamid-Copolymere, PET-Copolyester, Anhydride von einfachen und mehrfachen Carbonsäuren wie Essigsäureanhydrid, Propionsäureanhydrid, Buttersäureanhydrid oder Methyltetrahydrophtalsäureanhydrid, Isocyanate oder weitere auf Hybridpolymeren basierte Absorber, die meist in Kombination mit Katalysatoren wie beispielsweise Cobalt verwendet werden; weitere organische Absorber wie etwa schwach vernetzte Polyacrylsäure, Polyvinylalkohol, Ascorbate, Glucose, Gallussäure oder ungesättigte Fette und Öle. Vorteilhaft eingesetzt, insbesondere für die Bindung von Sauerstoff, werden weiterhin metallorganische Oxidationsadditive auf der Basis chelatbildender Amine und Übergangsmetallkomplexe, insbesondere in Verbindung mit oxidierbaren Substratmaterialien.
Erfindungsgemäß können auch Mischungen aus zwei oder mehreren Gettermaterialien eingesetzt werden.

Die Gettermaterialien werden ihrer Funktion entsprechend bevorzugt als im Wesentlichen von Permeaten freie Materialien eingesetzt, zum Beispiel wasserfrei. Dies unterscheidet Gettermaterialien von ähnlichen Materialien, die als Füllstoff eingesetzt werden. So wird Silica zum Beispiel in der Form von pyrogener Kieselsäure häufig als Füllstoff eingesetzt. Wird dieser Füllstoff jedoch wie üblich unter Umgebungsbedingungen gelagert, nimmt er bereits Wasser aus der Umgebung auf und ist nicht mehr in technisch nutzbarem Umfang als Gettermaterial funktionsfähig. Erst getrocknetes oder trocken gehaltenes Silica kann als Gettermaterial genutzt werden. Es ist erfindungsgemäß jedoch auch möglich, bereits teilweise mit Permeaten komplexierte Materialien zu verwenden, beispielsweise CaSO₄*1/2H₂O (Calciumsulfat-Halbhydrat) oder teilhydrierte Kieselsäuren, die per Definition als Verbindungen der allgemeinen Formel (SiO₂)ₘ*nH₂O vorliegen.

Unter Kieselsäuren werden, wie vorstehend beschrieben, Verbindungen der allgemeinen Formel (SiO2)m*nH2O verstanden. Es handelt sich dabei um durch nasschemische, thermische oder pyrogene Verfahren hergestelltes Siliciumdioxid. Insbesondere sind unter den Kieselsäuren Kieselgele beziehungsweise Silicagele, beispielsweise mit KobaltVerbindungen als Feuchteindikator imprägnierte Kieselgele (Blaugel), und pyrogene Kieselsäuren geeignete Gettermaterialien. Von den SiO2-Verbindungen ist ferner Kieselgur geeignet, das jedoch allgemein nicht den Kieselsäuren zugerechnet wird.

Für das Binden von Sauerstoff ist das Gettermaterial bevorzugt ausgewählt aus der Gruppe umfassend Eisen, Natriumdithionit, Bariumoxid, Eisen(II,III)-Oxid, Carbohydrazid, aktiviertes Aluminiumoxid, Zeolith, Aktivkohle, Sulfite, Ascorbate, Hydrazin, Morpholin, 2-Butanonoxim, Diethylhydroxylamin, Glucose, Gallussäure, ungesättigte Fette und Öle. metallorganische Oxidationsadditive auf der Basis chelatbildender Amine und Übergangsmetallkomplexe, insbesondere in Verbindung mit oxidierbaren Substratmaterialien.

Bevorzugt ist das Gettermaterial ausgewählt aus der Gruppe umfassend Cobaltchlorid, Calciumchlorid, Calciumbromid, Lithiumchlorid, Lithiumbromid, Magnesiumchlorid, Bariumperchlorat, Magnesiumperchlorat, Zinkchlorid, Zinkbromid, Aluminiumsulfat, Calciumsulfat, Kupfersulfat, Bariumsulfat, Magnesiumsulfat, Lithiumsulfat, Natriumsulfat, Cobaltsulfat, Titansulfat, Natriumcarbonat, Natriumsulfat, Kaliumcarbonat, Zeolithe, Calcium, Magnesium, Bariumoxid, Calciumoxid, Magnesiumoxid, Natriumoxid, Kaliumoxid, Strontiumoxid, Aktivkohle, Phosphorpentoxid, Silane, Calciumhydrid, Bariumhydrid, Strontiumhydrid, Natriumhydrid und Lithiumaluminiumhydrid, Kaliumhydroxid, Natriumhydroxid, Essigsäureanhydrid, Propionsäureanhydrid, Buttersäureanhydrid, Methyltetrahydrophtalsäureanhydrid und Carbodiimide sowie Mischungen von zwei oder mehreren der vorstehenden Substanzen. Diese Materialien weisen eine hohe Sorptionskapazität gegenüber mindestens einem der oben genannten Permeate und insbesondere auch gegenüber Wasser auf.

Unter "Carbodiimiden" werden Verbindungen der allgemeinen Formel R¹-N=C=N-R² verstanden, wobei R¹ und R² organische Reste, insbesondere Alkyl- oder Arylreste sind, die gleich oder verschieden sein können.

Ganz besonders bevorzugt ist das Gettermaterial ausgewählt aus Calciumoxid, Calciumsulfat, Calciumchlorid und Zeolithen sowie aus Mischungen von zwei oder mehreren der vorstehenden Substanzen. Diese Materialien weisen besonders hohe Kapazitäten für die Aufnahme von Wasser und weiteren Permeaten auf, sind größtenteils regenerierbar, lassen sich hervorragend in die Klebemasse einarbeiten und beeinträchtigen die Funktion dieser Schicht in der erfindungsgemäßen Menge gar nicht beziehungsweise nur in vernachlässigbarer Art und Weise.

Bevorzugt ist das Gettermaterial molekular in dem Matrixmaterial dispergiert, da hierdurch sowohl Transparenz als auch die Oberflächenrauheit im Vergleich zu Partikeln weniger beeinträchtigt werden. Die wasseraufnehmende Funktion und die lichtstreuende Funktion des Klebstoffs werden hiermit funktional getrennt, da das molekular dispergierte Gettermaterial keine lichtstreuende Wirkung mehr aufweist. Hierfür werden insbesondere Isocyanate, Metallkomplexe, Silane und organische Metallverbindungen eingesetzt, bevorzugt solche organometallischen Lewissäuren, die bei einer Reaktion mit Wasser keinen Alkohol bilden. Dies ist bevorzugt, da der Alkohol ähnlich wie Wasser eine Degradation des organischen elektronischen Aufbaus bewirken kann. Beispiele für solche Verbindungen sind Al(C₂H₅)₃, Al(C₄H₉)₃, B(C₄H₉)₃, Zn(C₄H₉)₂, Al(t-butyl)₃, Ti(t-butyl)₄, Mg(t-butyl)₂, Al(C₄H₉)₂(N(C₆H₅)₂), Al(C₄H₉)(N(C₆H₅)₂)₂, sowie weitere, wie sie in US2006/0087230 beschrieben werden.
Unter "Silanen" werden Verbindungen der allgemeinen Formel Rₐ-Si-X₄₋ₐ oder deren partielle Kondensationsprodukte verstanden. In der Formel steht a für eine ganze Zahl von 0 bis 3 und bevorzugt für 0 oder 1. X steht für eine hydrolysierbare Gruppe, beispielsweise und bevorzugt für ein Halogen-Atom, insbesondere Chlor, eine Alkoxy-Gruppe wie beispielsweise eine Methoxy-, Ethoxy-, n-Propoxy-, iso-Propoxy-, n-Butoxy-, sec-Butoxy- oder tert-Butoxy-Gruppe oderfür eine Acetoxy-Gruppe. Weitere, dem Fachmann bekannte Beispiele für hydrolysierbare Gruppen sind im Sinne der vorliegenden Erfindung ebenfalls einsetzbar. Sind mehrere Substituenten X vorhanden, so können diese gleich oder voneinander verschieden sein. R steht für einen gegebenenfalls substituierten Kohlenwasserstoffrest, beispielsweise für eine Methyl-, Ethyl-, n-Propyl-, iso-Propyl-, n-Butyl-, sec-Butyl-, tert-Butyl-Gruppe, eine Pentyl-Gruppe sowie deren verzweigte Isomere, eine Hexyl-Gruppen sowie die verzweigten Isomere, eine Heptyl-Gruppe sowie die verzweigten Isomere, eine Octyl-Gruppe sowie die verzweigten Isomere, eine Nonyl-Gruppe sowie die verzweigten Isomere, eine Decyl-Gruppe sowie die verzweigten Isomere, eine Undecyl-Gruppe sowie die verzweigten Isomere, eine Dodecyl-Gruppe sowie die verzweigten Isomere, eine Tetradecyl-Gruppe sowie die verzweigten Isomere, eine Hexadecyl-Gruppe sowie die verzweigten Isomere, eine Octadecyl-Gruppe sowie die verzweigten Isomere oder eine Eicosyl-Gruppe sowie die verzweigten Isomere. Die Kohlenwasserstoffreste können zudem ringförmige und/oder aromatische Bauteile enthalten. Repräsentative Strukturen dafür sind Cyclohexyl-, Phenyl- und Benzyl-Gruppen. Gegebenenfalls enthält/enthalten der/die Kohlenwasserstoffrest(e) R beispielsweise einen oder mehrere Heteroatom-haltige Substituenten wie Aminogruppen, Aminoalkylgruppen, Glycidyloxygruppen, (Meth)acryloxygruppen und dergleichen. Sind mehrere Substituenten R vorhanden, so können diese gleich oder voneinander verschieden sein.

Ein als Gettermaterial einsetzbares Silan ist bevorzugt ausgewählt aus der Gruppe umfassend N-(2-Aminoethyl)-3-aminopropyltrimethoxysilan, N-(2-Aminoethyl)-3-aminopropyltriethoxysilan, 3-Aminopropyltrimethoxysilan, 3-Aminopropyltriethoxysilan, 3-Aminopropyldiethoxymethylsilan, N-(2-Aminoethyl)-3-aminopropyldimethoxymethylsilan, (N-Butyl)-3-aminopropyltrimethoxysilan, 3-(N-Ethylamino)-2-methylpropyltrimethoxysilan, 4-Amino-3,3-dimethylbutyltrimethoxysilan, 4-Amino-3,3-dimethylbutyldimethoxymethylsilan, (N-Cyclohexyl)-aminomethyldimethoxymethylsilan, (N-Cyclohexyl)-aminomethyltrimethoxysilan, (N-Phenyl)-3-aminopropyltrimethoxysilan, (N-Phenyl)-aminomethyldimethoxymethylsilan, (N-Benzyl-2-aminoethyl)-3-aminopropyltrimethoxysilan, [2-(N-Benzyl-N-vinylamino)-ethyl]-3-aminopropyltrimethoxysilan Hydrogenchlorid, [2-(N-Benzyl-N-vinylamino)-ethyl]-3-aminopropyltrimethoxysilan, Bis-(3-propyltriethoxysilyl)-amin, Vinyltrimethoxysilan, Vinyltriethoxysilan, Vinyl-tri(2-methoxyethoxy)-silan, Vinyltriisopropoxysilan, Vinyldimethoxymethylsilan, Vinyltriacetoxysilan, 3-Triethoxysilylpropylbernsteinsäureanhydrid, 3-Glycidyloxypropyltrimethoxysilan, 3-Glycidyloxypropyltriethoxysilan, 2-(3,4-Epoxycyclohexyl)-ethyltriethoxysilan, 3-Glycidyloxypropyldiethoxymethylsilan, 3-Methacryloyloxypropyltrimethoxysilan, 3-Methacryloyloxypropyltriethoxysilan, 3-Methacryloyloxypropyltriisopropoxysilan, 3-Methacryloyloxypropyldimethoxymethylsilan, 3-Methacryloyloxypropyldiethoxymethylsilan, 3-Chloropropyltrimethoxysilan, 3-Chloropropyltriethoxysilan, 3-Isocyanatopropyltrimethoxysilan, 3-Isocyanatopropyltriethoxysilan, Isocyanatomethyltrimethoxysilan, Isocyanatomethyldimethoxymethylsilan, Tris-[3-(trimethoxysilyl)-propyl]-isocyanurat, 3-Ureidopropyltrimethoxysilan, 3-Ureidopropyltriethoxysilan, 2-Hydroxy-4-(3-triethoxysilylpropoxy)-benzophenon, 4-(3'-Chlorodimethylsilylpropoxy)-benzophenon, 3-Mercaptopropyltrimethoxysilan, 3-Mercaptopropyldimethoxymethylsilan, Bis-(3-triethoxysilylpropyl)-disulfan, Bis-(3-triethoxysilylpropyl)-tetrasulfan, Bis-(triethoxysilylpropyl)-polysulfan und Octadecylaminodimethyltrimethoxysilylpropylammoniumchlorid.
Das Einbringen des Gettermaterials oder der Gettermaterialien in die Klebemasse kann durch sämtliche dem Fachmann bekannte Verfahren erfolgen. Dabei kann das Gettermaterial in Lösung, Dispersion, Schmelze oder als Fluid vorliegen.

Die Klebemasse auf Basis von Styrolblockcopolymer, Polybutylen oder Polyolefin ist bevorzugt eine Haftklebemasse oder eine aktivierbare Klebemasse und insbesondere eine aktivierbare Haftklebemasse.

Ebenfalls im Sinne der Erfindung sind Kombinationen und Mischungen mehrerer Basispolymere sowie mit Klebharzen, Füllstoffen, Alterungsschutzmitteln und Vernetzern additivierte Klebemassen einsetzbar, wobei die Aufzählung der Additive nur beispielhaft und nicht einschränkend zu verstehen ist.

Sehr bevorzugt werden Klebemassen verwendet, die wasserfrei gehalten werden können oder die aufgrund ihrer chemischen Natur dazu beitragen, dass der Wassergehalt so gering wie möglich gehalten werden kann. Dies lässt sich insbesondere erzielen durch die Verwendung von (Haft-)klebemassen mit unpolaren Eigenschaften. Erfindungsgemäß sehr vorteilhaft werden daher (Haft-)klebemassen auf Basis von Synthesekautschuken; Styrolblockcopolymermassen mit einem Elastomerblock aus ungesättigten oder hydrierten Polydienblöcken wie zum Beispiel Polybutadien, Polyisopren, Copolymere aus beiden sowie weitere, dem Fachmann geläufige Elastomerblöcke; Haftklebemassen auf Basis von Polyolefinen eingesetzt. Erfindungsgemäß sind (Haft-)Klebemassen auf der Basis von Styrolblockcopolymeren, Polybutylenen und Polyolefinen, da sich diese durch eine hohe Permeationsbarriere gegen Wasserdampf sowie einen geringen Gehalt an Wasser auszeichnen.
Hitzeaktiviert verklebende Klebemassen lassen sich grundsätzlich in zwei Kategorien einordnen: thermoplastische hitzeaktiviert verklebende Klebemassen (Schmelzklebstoffe) und reaktive hitzeaktiviert verklebende Klebemassen (Reaktivklebstoffe). Ebenfalls umfasst sind solche Klebemassen, die sich beiden Kategorien zuordnen lassen, nämlich reaktive thermoplastische hitzeaktiviert verklebende Klebemassen (reaktive Schmelzklebstoffe).

Thermoplastische Klebemassen basieren auf Polymeren, die bei einem Erwärmen reversibel erweichen und während des Erkaltens wieder erstarren. Als thermoplastische Klebemassen haben sich insbesondere solche auf der Basis von rein alkeinischen Polyolefinen als vorteilhaft herausgestellt. Copolymere von Polyolefinen mit Nichtalkenen, wie z.B. Ethylenvinylacetat (EVA), und säurebasierte Derivate von alkenischen Polyolefinen weisen oft bereits eine höheren WVTR als 100 g/m² auf.
Auch hier werden erfindungsgemäß besonders bevorzugt die aktivierbaren Klebemassen ausgewählt, die unpolare Eigenschaften besitzen, da hierdurch der Wassergehalt gering gehalten werden kann und die Barierrewirkung gegen Wasserdampf gut ist. Insbesondere die Klebemassen auf Basis von Polyolefinen, werden daher besonders bevorzugt.
Im Gegensatz dazu enthalten reaktive hitzeaktiviert verklebende Klebemassen reaktive Komponenten. Letztere Bestandteile werden auch als "Reaktivharze" bezeichnet, in denen durch das Erwärmen ein Vernetzungsprozess eingeleitet wird, der nach Beenden der Vernetzungsreaktion eine dauerhafte stabile Verbindung gewährleistet. Derartige Klebemassen enthalten auch elastische Komponenten, zum Beispiel synthetische Nitrilkautschuke oder Stryrolblockcopolymere. Derartige elastische Komponenten verleihen der hitzeaktiviert verklebenden Klebemasse infolge ihrer hohen Fließviskosität eine auch unter Druck besonders hohe Dimensionsstabilität.

Besonders bevorzugt werden als reaktive hitzeaktiviert verklebende Klebemassen diejenigen auf Basis von Styrolblockcopolymeren aufgrund ihres unpolaren Charakters und der dadurch in der Regel nach der Aktivierung gegebenen WVTR von weniger als 100 g/m²d.

Strahlungsaktivierte Klebemassen basieren ebenfalls auf reaktiven Komponenten. Letztere Bestandteile können zum Beispiel Polymere oder Reaktivharze umfassen, in denen durch die Bestrahlung ein Vernetzungsprozess eingeleitet wird, der nach Beenden der Vernetzungsreaktion eine dauerhafte stabile Verbindung gewährleistet. Bevorzugt enthalten derartige Klebemassen auch elastische Komponenten, wie sie oben ausgeführt sind.
Aktivierbare Klebemassen auf Basis von (Meth-)Acrylaten können aufgrund der zu hohen WVTR nicht eingesetzt werden; bevorzugt werden aktivierbare Klebemassen auf der Basis von modifizierten Styrolblockcopolymeren, eingesetzt.
Bevorzugt weist der erfindungsgemäße Klebstoff selbst einen Permeatgehalt von weniger als 1000 ppm, besonders bevorzugt von weniger als 500 ppm auf. Die Angabe ppm bezieht sich dabei auf die Relation des enthaltenen Gesamtgewichts an Permeaten zum untersuchten Klebemassegewicht. Der Permeatgehalt kann mittels der Gaschromatographie nach VDA 277 bestimmt werden oder im Fall von Wasser nach DIN EN ISO 62 (gravimetrisches Verfahren, Methode 4) oder DIN 53715 (Karl-Fischer-Titration) nach Lagerung des Prüflings über 24 Stunden bei 23 °C und 50 % relativer Luftfeuchte. Bei geringen Permeatgehalten der Klebemasse wird weniger Permeat durch den Klebstoff selbst in den elektronischen Aufbau eingebracht und gegebenenfalls die Kapazität der Gettermaterialien nicht so stark durch in der Klebemasse enthaltene Permeate beansprucht, sondern der Klebstoff kann seine Funktion als vor Permeaten aus der Umgebung schützende oder sogar Permeate aus der elektronischen Anordnung selbst bindende Abdeckung besser erfüllen.

Die Klebemasse weist eine Permeationsrate für Wasserdampf von weniger als 100 g/(m² d) auf. Bevorzugt beträgt die Wasserdampfpermeationsrate (WVTR) weniger als 50 g/(m² d), besonders bevorzugt weniger als 20 g/(m² d) bezogen auf eine Klebemassedicke von 50 µm. Die WVTR wird dabei bei 38 °C und 90 % relativer Luftfeuchtigkeit nach ASTM F-1249 gemessen.

Bevorzugt weist die Klebemasse auch eine die Sauerstoffpermeationsrate (OTR) von weniger als 5000 cm³ /m² d bar insbesondere weniger als 2000 cm³ /m² d bar gemessen bei 23 °C und 50 % relativer Luftfeuchtigkeit nach DIN 53380-Teil 3 auf..

Durch die geringe Permeationsrate der Klebemasse diffundiert weniger Permeat aus der Umgebung durch den Klebstoff hindurch in die elektronische Anordnung, deren Lebensdauer sich dadurch erhöht.
Als (Haft-)Klebemassen mit inhärenter Barrierewirkung, insbesondere als solche (Haft-)Klebemassen, die bei einer Dicke von 50 µm eine Wasserdampfpermeationsrate von weniger als 50 g/(m²·d) und/oder eine Sauerstoffdurchtrittsrate von weniger als 5000 cm³/(m²·d·bar) aufweisen, lassen sich beispielweise - ohne die Absicht einer Einschränkung auf die genannten Beispiele - einsetzen, sofern es sich um Klebemassen auf der Basis von Styrolblockcopolymer, Polybutylen oder Polyolefin handelt:
- Klebemassen auf Basis von Vinylaromatenblockcopolymeren,
   - insbesondere wie sie beispielsweise in der DE 10 2008 047 964 A dargestellt sind. Dies sind insbesondere Haftklebmassen. In einer vorteilhaften Ausgestaltung enthalten solche Haftklebemasse Polymerblöcke die aus Vinylaromaten gebildet sind, insbesondere aus Styrol; weiterhin enthalten sie vorteilhaft Polymerblöcke, die durch Polymerisation von 1,3-Dienen, insbesondere Butadien und/oder Isopren, gebildet sind, und/oder spezifisch oder vollständig hydrierte Polymerblöcke Der Polyvinylaromatenanteil der Blockcopolymere beträgt vorteilhaft 10 Gew.-% bis 35 Gew.-%. In bevorzugter Weise weist die Haftklebemasse einen Anteil der Vinylaromatenblockcopolymere von mindestens 20 Gew.-%, vorzugsweise von mindestens 30 Gew.-%, weiter bevorzugt von mindestens 35 Gew.-%, auf; und/oder sie weist einen Anteil der Vinylaromatenblockcopolymere von maximal 80 Gew.-%, vorzugsweise von maximal 65 Gew.-%, weiter bevorzugt von maximal 60 Gew.-%, auf. Die Haftklebemasse kann ein oder mehrere Harze oder ein oder mehrere Harzgemische enthalten, vorzugsweise hydrierte Harze mit einem Hydrierungsgrad von mindestens 90%, weiter bevorzugt von mindestens 95%. In einer bevorzugten Variante enthält sie zumindest ein Harz, das einen DACP-Wert von mehr als 30 °C und einen MMAP-Wert von mehr als 50 °C aufweist, vorzugsweise einen DACP-Wert von mehr als 37 °C und einen MMAP-Wert von mehr als 60 °C, und/oder die Haftklebemasse enthält zumindest ein Harz, das eine Erweichungstemperatur von mehr als 95 °C, insbesondere von mehr als 100 °C aufweist. Es können ein oder mehrere Additive enthalten sein, vorzugsweise ausgewählt aus der Gruppe bestehend aus: Plastifizierungsmitteln, primären Antioxidantien, sekundären Antioxidantien, Prozessstabilisatoren, Lichtschutzmitteln, Verarbeitungshilfsmittel, Endblockverstärkerharzen, Polymeren, insbesondere elastomerer Natur. Vorteilhaft ist es, wenn die Haftklebemasse, insbesondere nach einer Vernetzung, eine Reißdehnung von mindestens 20 % aufweist,
   - insbesondere wie sie beispielweise in der DE 10 2009 036 970 A beschrieben sind. Genannt seien insbesondere teilweise vernetzte Haftklebmasse auf Basis von säure- oder säureanhydridmodifizierten Vinylaromatenblockcopolymeren. Sehr vorteilhaft enthält die Haftklebemasse Polymerblöcke gebildet aus Vinylaromaten, insbesondere Styrol. Weiter vorteilhaft sind solche Haftklebemassen auf Basis von säure- oder säureanhydridmodifizierten Vinylaromatenblockcopolymeren, die Polymerblöcke gebildet durch Polymerisation von 1,3-Dienen, insbesondere Butadien und/oder Isopren, und/oder spezifisch oder vollständig hydrierte Polymerblöcke enthält.
      Diese Haftklebemassen können vorteilhaft mit Aminen und/oder Epoxidharzen und/oder Metallchelaten vernetzt sein. Als Metallchelate können bevorzugt solche verwendet werden, die durch die Formel (R₁O)ₙ M (XR₂Y)ₘ wiedergegeben werden können, wobei M ein Metall der 2. 3. 4. und 5. Hauptgruppe oder ein Übergangsmetall ist; R₁ eine Alkyl- oder Arylgruppe wie Methyl, Ethyl, Butyl, Isopropyl oder Benzyl ist; n null oder eine größere ganze Zahl ist, X und Y Sauerstoff oder Stickstoff sind, die jeweils auch durch eine Doppelbindung an R2 gebunden sein können; R₂ eine X und Y verbindende Alkylengruppe ist, die verzweigt sein kann, oder auch Sauerstoff oder weitere Heteroatome in der Kette enthalten kann; m eine ganze Zahl, mindestens jedoch 1 ist. Vorteilhaft kann es sich bei dem Chelat um ein Acetylacetonat handelt, insbesondere um Aluminiumacetylacetonat.
      In einer vorteilhaften Ausführung weisen die Blockcopolymere einen Polyvinylaromatenanteil von 10 Gew.-% bis 35 Gew.-% aufweisen. Der Anteil der Vinylaromatenblockcopolymere in der Haftklebemasse beträgt bevorzugt mindestens 30 Gew.-%, vorzugsweise mindestens 40 Gew.-%, weiter bevorzugt mindestens 45 Gew.-%. Vorteilhaft sollte der Anteil der Vinylaromatenblockcopolymere in der Haftklebemassen 80 Gew.-%, vorzugsweise 70 Gew.-%, nicht übersteigen.
      Die Haftklebemasse kann ein Harz oder ein Harzgemisch enthalten, vorzugsweise hydrierte Harze mit einem Hydrierungsgrad von mindestens 90 %, weiter bevorzugt von mindestens 95 %. Die Haftklebemasse kann ein oder mehrere Additive enthalten, vorzugsweise ausgewählt aus der Gruppe umfassend Plastifizierungsmitteln, primären Antioxidanzien, sekundären Antioxidanzien, Prozessstabilisatoren, Lichtschutzmitteln, Verarbeitungshilfsmittel, Endblockverstärkerharzen, Polymeren, insbesondere elastomerer Natur. Die Haftklebemasse kann einen oder mehrere Füllstoffe enthalten, wie nanoskalige Füllstoffe, transparente Füllstoffe. Vorteilhaft sind die Füllstoffe in mindestens einer Dimension nanoskalig ausgebildet.
- Klebemassen auf Polyolefinbasis, insbesondere wie sie beispielsweise in der DE 10 2008 062 130 A beschrieben sind. Haftklebemassen auf Basis eines teilkristallinen Polyolefins sind besonders bevorzugt, wobei das Polyolefin eine Dichte zwischen 0,86 und 0,89 g/cm³, bevorzugt zwischen 0,86 und 0,88 g/cm³, sehr bevorzugt zwischen 0,86 und 0,87 g/cm³, und einen Kristallitschmelzpunkt von mindestens 90 °C, bevorzugt von mindestens 115 °C, sehr bevorzugt von mindestens 135 °C aufweist. Vorteilhaft ist das Polyolefin mit mindestens einem Klebharz kombiniert, wobei vorzugsweise die Menge an Klebharz 130 bis 350 phr, besonders bevorzugt 200 bis 240 phr beträgt. Weiter vorteilhaft enthält die Haftklebemasse ein hydriertes Harz, vorzugsweise mit einem Hydrierungsgrad von mindestens 90 %, besonders bevorzugt von mindestens 95 %. Es können ein oder mehrere Additive enthalten sein, vorzugsweise ausgewählt aus der Gruppe bestehend aus: Weichmacher, primären Antioxidantien, sekundären Antioxidantien, Prozessstabilisatoren, Lichtschutzmitteln, Verarbeitungshilfsmittel, UV-Blocker.
- Klebemassen auf Isobutylenbasis und/oder auf Butylenblockcopolymerbasis, insbesondere solche beispielsweise gemäß der DE 10 2008 060 113 A. Besonders bevorzugt sind Haftklebmassen auf Basis von Isobutylenblockcopolymeren. Bevorzugt enthält die Haftklebemasse Polymerblöcke gebildet aus Vinylaromaten, insbesondere Styrol, enthält, und Polymerblöcke, die durch Polymerisation von Isobutylen oder von Isobutylen in Kombination mit n-Buten und/oder 1,3-Dienen, insbesondere Butadien und/oder Isopren, gebildet werden. Die Blockcopolymere weisen bevorzugt einen Polyvinylaromatenanteil von 10 Gew.-% bis 35 Gew.-%. Bevorzugt beträgt der Anteil der Blockcopolymere an der Haftklebemasse mindestens 20 Gew.-%, vorzugsweise mindestens 30 Gew.-%, weiter bevorzugt mindestens 35 Gew.-%, und/oder maximal 90 Gew.-%, vorzugsweise maximal 75 Gew.-%, weiter bevorzugt maximal 70 Gew.-%. Es ist von Vorteil, wenn der Anteil der Isobutylenblockcopolymere am Gesamtanteil der Blockcopolymere mindestens 40 Gew.-%, vorzugsweise mindestens 55 Gew.-% beträgt. Die Haftklebemasse kann ein Harz oder ein Harzgemisch enthalten; vorzugsweise enthält sie hydrierte Harze mit einem Hydrierungsgrad von mindestens 90 %, weiter bevorzugt von mindestens 95 %. Das in der Haftklebemasse enthaltenen Harz weist bevorzugt einen DACP-Wert von mehr als 30 °C und einen MMAP-Wert von mehr als 50 °C, vorzugsweise einen DACP-Wert von mehr als 37 °C und einen MMAP-Wert von mehr als 60 °C, und/oder eine Erweichungstemperatur von mehr als 95 °C, insbesondere von mehr als 100 °C auf. Es können ein oder mehrere Additive enthalten sein, vorzugsweise ausgewählt aus der Gruppe bestehend aus: Plastifizierungsmitteln, primären Antioxidantien, sekundären Antioxidantien, Prozessstabilisatoren, Lichtschutzmitteln, Verarbeitungshilfsmittel, Endblockverstärkerharzen, Polymeren, insbesondere elastomerer Natur.
- Klebemassen, wie sie beispielsweise in der DE10 2012 202 377 A1 beschrieben sind, umfassend bevorzugt (a) zumindest ein Copolymer enthaltend zumindest Isobutylen oder Butylen als Comonomersorte und zumindest eine Comonomersorte, die - als hypothetisches Homopolymer betrachtet - eine Erweichungstemperatur von größer 40 °C aufweist, (b) zumindest eine Sorte eines zumindest teilhydrierten Klebharzes, (c) zumindest eine Sorte eines Reaktivharzes basierend auf cyclischen Ethern mit einer Erweichungstemperatur von kleiner 40 °C, bevorzugt kleiner 20 °C, (d) zumindest eine Sorte eines Photoinitiators für die Initiierung einer kationischen Härtung; und weniger bevorzugt Klebemassen umfassend (a) zumindest ein Copolymer enthaltend zumindest Isobutylen oder Butylen als Comonomersorte und zumindest eine Comonomersorte, die - als hypothetisches Homopolymer betrachtet - eine Erweichungstemperatur von größer 40 °C aufweist, (b) zumindest eine Sorte eines zumindest teilhydrierten Klebharzes, (e) zumindest eine Sorte eines Reaktivharzes basierend auf Acrylaten oder Methacrylaten mit einer Erweichungstemperatur von kleiner 40 °C, bevorzugt kleiner 20 °C, (d) zumindest eine Sorte eines Photoinitiators für die Initiierung einer kationischen Härtung.
Das oder die Copolymere können beispielweise statistische, alternierende, Block-, Stern- und/oder Pfropfcopolymere mit einer Molmasse M_{w} von 300.000 g/mol oder kleiner, bevorzugt 200.000 g/mol oder kleiner sind. Das oder die Copolymere Block-, Stern- und/oder Pfropfcopolymere weisen in einer bevorzugten Ausführungsform zumindest eine Sorte eines ersten Polymerblocks ("Weichblock") mit einer Erweichungstemperaturvon kleiner -20 °C und zumindest eine Sorte eines zweiten Polymerblocks ("Hartblock") mit einer Erweichungstemperatur von größer +40 °C auf. Dabei kann der Weichblock unpolar aufgebaut sein und Butylen oder Isobutylen als Homopolymerblock oder Copolymerblock enthalten, letztere vorzugsweise mit sich selbst oder miteinander oder mit weiteren besonders bevorzugt unpolaren Comonomeren copolymerisiert. Vorteilhaft ist es, wenn der Hartblock aus Styrol, Styrol-Derivaten und/oder aus anderen aromatischen oder (cyclo-)aliphatischen Kohlenwasserstoffmonomeren aufgebaut ist. Weiter vorteilhaft ist es, wenn es sich bei dem zumindest einen Blockcopolymer um ein Triblockcopolymer handelt, das aus zwei endständigen Hartblöcken und einem mittelständigen Weichblock aufgebaut ist. Das oder die Klebharze weisen bevorzugt einen Hydrierungsgrad von mindestens 70 %, weiter bevorzugt von mindestens 95 % auf. Vorteilhaft kann die Klebemasse ein oder mehrere Additive, unabhängig voneinander gewählt aus der folgenden Gruppe, enthalten:
Harze, die einen DACP-Wert von mehr als 30 °C und einen MMAP-Wert von mehr als 50 °C aufweisen, vorzugsweise einen DACP-Wert von mehr als 37 °C und einen MMAP-Wert von mehr als 60 °C;
Reaktivharze, die zumindest eine Epoxid- oder zumindest eine Oxetan-Gruppe tragen; Reaktivharze aliphatischer oder cycloaliphatischer Natur,
Photoinitiatoren, die unterhalb 350 nm UV-Licht absorbieren und die eine kationische Härtung erlauben, insbesondere Sulfonium-, lodonium- und Metallocen-basierende Systeme;
Photoinitiatoren, die oberhalb 250 nm und unterhalb 350 nm UV-Licht absorbieren;
Plastifizierungsmittel,
primäre Antioxidantien,
sekundäre Antioxidantien,
Prozessstabilisatoren,
Lichtschutzmittel,
Verarbeitungshilfsmittel,
Endblockverstärkerharze,
Polymere, insbesondere elastomerer Natur;
Füllstoffe, vorzugsweise nanoskalige Füllstoffe, transparente Füllstoffe und/oder Getter-und/oder Scavenger-Füllstoffe.

Auf die in den jeweils genannten Schriften offenbarten Sachverhalte wird explizit Bezug genommen. Die Nennung der vorgenannten Beispiele soll die Wahl der erfindungsgemäß geeigneten Klebemassen nicht unnötig beschränken.

Ein weiterer Gegenstand der Offenbarung ist eine optoelektronische, insbesondere eine organische optoelektronische Anordnung umfassend zumindest eine optoelektronische Struktur und eine Schicht eines erfindungsgemäßen Klebstoffs, wobei die Klebstoffschicht die optoelektronische Struktur vollflächig überdeckt.

Weitere Einzelheiten, Merkmale und Vorteile der vorliegenden Erfindung werden nachfolgend anhand bevorzugter Ausführungsbeispiele näher erläutert. In der Zeichnung zeigt
Fig. 1 eine (opto-)elektronische Anordnung nach dem Stand der Technik in schematischer Darstellung,
Fig. 2 eine erste erfindungsgemäße (opto-)elektronische Anordnung in schematischer Darstellung,
Fig. 3 eine zweite erfindungsgemäße (opto-)elektronische Anordnung in schematischer Darstellung.

Fig. 1 zeigt eine erste Ausgestaltung einer organischen elektronischen Anordnung 1 nach dem Stand der Technik. Diese Anordnung 1 weist ein Substrat 2 auf, auf dem eine elektronische Struktur 3 angeordnet ist. Das Substrat 2 selbst ist als Barriere für Permeate ausgebildet und bildet damit einen Teil der Kapselung der elektronischen Struktur 3. Oberhalb der elektronischen Struktur 3, vorliegend auch räumlich von dieser beabstandet, ist eine weitere als Barriere ausgebildete Abdeckung 4 angeordnet.

Um die elektronische Struktur 3 auch zur Seite hin zu kapseln und gleichzeitig die Abdeckung 4 mit der elektronischen Anordnung 1 im Übrigen zu verbinden, ist ein Klebstoff 5 umlaufend neben der elektronischen Struktur 3 auf dem Substrat 2 vorgesehen. Dabei ist es unerheblich, ob der Klebstoff zunächst mit dem Substrat 2 verbunden wurde oder zuerst mit der Abdeckung 4. Der Klebstoff 5 verbindet die Abdeckung 4 mit dem Substrat 2. Durch eine entsprechend dicke Ausgestaltung ermöglicht der Klebstoff 5 zudem die Beabstandung der Abdeckung 4 von der elektronischen Struktur 3.

Bei dem Klebstoff 5 handelt es sich um eine solche nach dem Stand der Technik, also einen Klebstoff mit hoher Permeationsbarriere, der zudem zu einem hohen Anteil mit Gettermaterial gefüllt sein kann. Die Transparenz des Klebstoffs ist in diesem Aufbau nicht relevant.

Ein Transferklebeband würde vorliegend in Form eines Stanzlings bereitgestellt, welcher aufgrund seiner filigranen Geometrie schwieriger handzuhaben ist als ein im Wesentlichen vollflächig appliziertes Transferklebeband.

Fig. 2 zeigt eine erfindungsgemäße Ausgestaltung einer (opto-)elektronischen Anordnung 1. Gezeigt ist wiederum eine elektronische Struktur 3, die auf einem Substrat 2 angeordnet und durch das Substrat 2 von unten gekapselt ist. Oberhalb und seitlich von der elektronischen Struktur ist nun der erfindungsgemäße Klebstoff, zum Beispiel in der Ausführung als Transferklebeband 6 vollflächig angeordnet. Die elektronische Struktur 3 wird somit von oben vollständig durch das Transferklebeband 6 gekapselt. Auf das Transferklebeband 6 ist sodann eine Abdeckung 4 aufgebracht. Bei dem Transferklebeband 6 handelt es sich um ein solches auf Basis des erfindungsgemäßen Transferklebebands wie es vorstehend in allgemeiner Form beschrieben wurde und nachfolgend in Ausführungsbeispielen näher dargelegt ist. Das Transferklebeband besteht in der dargestellten Ausführung nur aus einer Schicht eines erfindungsgemäßen Klebstoffs.

Die Abdeckung 4 muss im Gegensatz zu der vorherigen Ausgestaltung nicht zwingend die hohen Barriereanforderungen erfüllen, da bei vollflächiger Überdeckung der elektronischen Anordnung durch das Transferklebeband die Barriere bereits durch den Klebstoff bereitgestellt wird. Die Abdeckung 4 kann beispielsweise lediglich eine mechanische Schutzfunktion wahrnehmen, sie kann aber auch zusätzlich als Permeationsbarriere vorgesehen sein.

Fig. 3 zeigt eine alternative Ausgestaltung einer (opto-)elektronischen Anordnung 1. Im Gegensatz zu den vorherigen Ausgestaltungen sind nun zwei Transferklebebänder 6a, b vorgesehen, die vorliegend identisch ausgebildet sind, aber auch unterschiedlich sein können. Das erste Transferklebeband 6a ist vollflächig auf dem Substrat 2 angeordnet. Auf dem Transferklebeband 6a ist die elektronische Struktur 3 vorgesehen, die durch das Transferklebeband 6a fixiert wird. Der Verbund aus Transferklebeband 6a und elektronischer Struktur 3 wird dann mit dem weiteren Transferklebeband 6b vollflächig überdeckt, so dass die elektronische Struktur 3 von allen Seiten durch die Transferklebebänder 6a, b gekapselt ist. Oberhalb des Transferklebebands 6b ist wiederum die Abdeckung 4 vorgesehen.

In dieser Ausgestaltung müssen somit weder das Substrat 2 noch die Abdeckung 4 zwingend Barriereeigenschaften aufweisen. Sie können aber dennoch vorgesehen sein, um die Permeation von Permeaten zur elektronischen Struktur 3 weiter einzuschränken.

Insbesondere im Hinblick auf die Fig. 2 und 3 wird darauf hingewiesen, dass es sich vorliegend um schematische Darstellungen handelt. Aus den Darstellungen ist insbesondere nicht ersichtlich, dass das Transferklebeband hier und vorzugsweise jeweils eine homogene Schichtdicke aufweist. Am Übergang zur elektronischen Struktur bildet sich daher keine scharfe Kante, wie es in der Darstellung scheint, sondern der Übergang ist fließend und es können vielmehr kleine un- oder gasgefüllte Bereiche verbleiben. Gegebenenfalls kann jedoch auch eine Anpassung an den Untergrund erfolgen, insbesondere dann, wenn die Applikation unter Vakuum durchgeführt wird und/oder ein Autoklavierschritt folgt.. Zudem wird die Klebemasse lokal unterschiedlich stark komprimiert, so dass durch Fließprozesse ein gewisser Ausgleich der Höhendifferenz an den Kantenstrukturen erfolgen kann. Auch die gezeigten Dimensionen sind nicht maßstäblich, sondern dienen vielmehr nur einer besseren Darstellung. Insbesondere die elektronische Struktur selbst ist in der Regel relativ flach ausgebildet (oft weniger als 1 µm dick).

Auch ist ein direkter Kontakt des Klebstoffs mit dem elektronischen Aufbau nicht zwingend vorzusehen. Es können auch weitere Schichten dazwischen angeordnet sein wie zum Beispiel eine Dünnschichtverkapselung des elektronischen Aufbaus oder Barrierefilme.

Die Dicke des Transferklebebands kann alle üblichen Dicken umfassen, also etwa von 1 µm bis zu 3000 µm. Bevorzugt wird eine Dicke zwischen 25 und 100 µm, da in diesem Bereich Klebkraft und Handlingeigenschaften besonders positiv ausfallen. Ein weiterer bevorzugter Bereich ist eine Dicke von 3 bis 25 µm, da in diesem Bereich die Menge von durch die Klebefuge permeierenden Stoffen allein durch die kleine Querschnittsfläche der Klebefuge in einer Verkapselungsanwendung gering gehalten werden kann.

Zur Herstellung eines erfindungsgemäßen Transferklebebands wird der Träger des Klebebands oder der Liner einseitig mit dem erfindungsgemäßen Klebstoff aus Lösung oder Dispersion oder 100 %ig (zum Beispiel Schmelze) beschichtet oder bedruckt, oder das Klebeband wird durch (Co-)Extrusion hergestellt. Alternativ ist eine Herstellung durch Transfer einer erfindungsgemäßen Klebstoff-Schicht durch Kaschieren auf eine Trägermaterial oder einen Liner möglich. Die Klebstoffschicht kann durch Wärme oder energiereiche Strahlen vernetzt werden.

Bevorzugt findet dieser Herstellprozess in einer Umgebung statt, in der das spezifische Permeat nur in geringer Konzentration oder nahezu gar nicht enthalten ist. Als Beispiel kann eine relative Luftfeuchtigkeit von weniger als 30 %, bevorzugt von weniger als 15 % genannt werden.

Zur Optimierung der Eigenschaften kann der zum Einsatz kommende Klebstoff mit einem oder mehreren Additiven wie Klebrigmachern (Harzen), Weichmachern, Füllstoffen, Pigmenten, UV-Absorbern, Lichtschutzmitteln, Alterungsschutzmitteln, Vernetzungsmitteln, Vernetzungspromotoren oder Elastomeren abgemischt sein.

Die Menge einer Klebstoffschicht kann im Rahmen der im Klebebandbereich üblichen Menge liegen, also etwa von 1 bis 3000 g/m². Sie beträgt bevorzugt 1 bis 120 g/m², vorzugsweise 10 bis 100 g/m², wobei unter "Menge" die Menge nach einer eventuell durchgeführten Entfernung von Wasser oder Lösungsmittel verstanden wird.

### Prüfmethoden

Die Messungen werden bei einem Prüfklima von 23 ± 1 °C und 50 ± 5 % rel. Luftfeuchte durchgeführt.

### Messung des Haze und der Transmision:

Der HAZE-Wert beschreibt den Anteil des transmittierten Lichts, der von der durchstrahlten Probe nach vorne großwinklig gestreut wird. Somit quantifiziert der HAZE-Wert die opaken Eigenschaften einer Schicht, die die klare Durchsicht stören.
Die Transmission und der Haze des Klebstoffs wird analog ASTM D1003-11 (Procedure A (Hazemeter Byk Haze-gard Dual), Normlichtart D65) bei Raumtemperatur an einer 50 µm dicken Schicht des Klebstoffs bestimmt. Eine Korrektur von Grenzflächenreflextionsverlusten wird nicht vorgenommen.
Da bei dünnen Transferklebebändern die richtige Applikation am Messgerät wichtig ist, um das Messergebnis nicht zu verfälschen, wurde ein Hilfsträger verwendet. Als Träger wurde eine PC-Folie der Firma GE Plastics (Lexan 8010 Film, Dicke 125µm) verwendet.
Dieser Träger erfüllte alle Kriterien (glatte, plane Oberfläche, sehr geringer Haze-Wert, hohe Transmission, hohe Homogenität) um die Klebebandmuster plan am Messkanal anzubringen.
Die Messungen wurden an vernetzten Klebebändern vorgenommen.

### Messung des Brechungsindex:

Der Brechungsindex wird in Anlehnung an ISO 489 (Methode A, Messwellenlänge 589 nm) bei einer Temperatur von 20 °C und einer relativen Luftfeuchte von 50 % bestimmt. Aus den Partikeln wurden dazu Formkörper mittels Druck und Temperatur hergestellt. Als Kontaktflüssigkeit bei der Messung wurde Zimtöl verwendet.

### Messung der Wasserdampfpermeationsrate WVTR

Die WVTR wird dabei bei 38°C und 90% relativer Luftfeuchtigkeit nach ASTM F-1249. Es wird jeweils eine Doppelbestimmung durchgeführt und der Mittelwert gebildet. Der angegebene Wert ist auf eine Dicke von 50 µm normiert / ist bezogen auf die jeweilige Dicke des vermessenen Prüflings.
Die Transferklebebänder wurden für die Messungen auf eine hochpermeable Polysulfon-Membran (erhältlich von der Firma Sartorius) geklebt, die selbst keinen Beitrag zur Permeationsbarriere liefert. Die Messungen wurden an vernetzten Klebebändern vorgenommen.

### Lebensdauertest

Als ein Maß für die Bestimmung der Lebensdauer eines elektronischen Aufbaus wurde ein Calciumtest herangezogen. Dieser ist in der Figur 4 gezeigt. Dazu wird im Vakuum eine 10 x 10 mm² große, dünne Calciumschicht 23 auf eine Glasplatte 21 abgeschieden und danach unter Stickstoffatmosphäre gelagert. Die Dicke der Calciumschicht 23 liegt bei etwa 100 nm. Für die Verkapselung der Calciumschicht 23 wird ein Klebeband (23 x 23 mm²) mit der zu testenden Klebemasse 22 sowie einer Dünnglasscheibe 24 (30 µm, Firma Schott) als Trägermaterial verwendet. Zur Stabilisierung war die Dünnglasscheibe mit einer 100 µm dicken PET-Folie 26 mittels eines 50 µm dicken Transferklebebands 25 einer optisch hochtransparenten Acrylathaftklebemasse laminiert. Die Klebemasse 22 wird so auf der Glasplatte 21 appliziert, dass die Klebemasse 22 den Calciumspiegel 23 mit einem allseitig überstehenden Rand von 6,5 mm (A-A) abdeckt. Aufgrund des undurchlässigen Glasträgers 24 wird nur die Permeation durch den Haftkleber oder entlang der Grenzflächen ermittelt.

Der Test basiert auf der Reaktion von Calcium mit Wasserdampf und Sauerstoff, wie sie beispielsweise von A.G. Erlat et. al. in "47th Annual Technical Conference Proceedings-Society of Vacuum Coaters", 2004, Seiten 654 bis 659, und von M. E. Gross et al. in "46th Annual Technical Conference Proceedings-Society of Vacuum Coaters", 2003, Seiten 89 bis 92, beschrieben sind. Dabei wird die Lichttransmission der Calciumschicht überwacht, welche durch die Umwandlung in Calciumhydroxid und Calciumoxid zunimmt. Diese erfolgt beim beschriebenen Prüfaufbau vom Rand her, so dass sich die sichtbare Fläche des Calciumspiegels verringert. Es wird die Zeit bis zur Halbierung der Lichtabsorption des Calciumspiegels als Lebensdauer bezeichnet. Durch die Methode werden dabei sowohl der Abbau der Fläche des Calciumspiegels vom Rand aus und durch punktuellen Abbau in der Fläche als auch die homogene Verringerung der Schichtdicke des Calciumspiegels durch vollflächigen Abbau erfasst.

Als Messbedingungen wurden 60 °C und 90 % relative Luftfeuchte gewählt. Die Muster wurden mit einer Schichtdicke der Haftklebemasse von 50 µm vollflächig und blasenfrei verklebt. Die Messungen wurden an vernetzten Klebebändern vorgenommen. Der Messwert (in h) ergab sich als Mittelwert aus drei Einzelmessungen.

Aus der Zeit bis zum vollständigen Abbau des Calciumspiegels wird zudem eine Wasserdampfpermeationsrate (Ca-WVTR) berechnet. Dazu wird die Masse des aufgedampften Calciums mit dem Faktor 0.9 multipliziert (Massenverhältnis H₂O/Ca für die Umsetzungsreaktion von metallischem Calcium zu transparentem Calciumhydroxid) um die Masse des einpermeierten Wasserdampfes zu ermitteln. Diese wird auf den Permeationsquerschnitt (Umfangslänge des Testaufbaus x Klebemassedicke) sowie die Zeit bis zum vollständigen Abbau des Calciumspiegels bezogen. Der errechnete Messwert wird weiterhin durch die Breite des allseitig überstehenden Rands (in mm) geteilt und somit auf eine Permeationsstrecke von 1 mm normiert. Die Angabe des Ca-WVTR erfolgt in g/m²*d.

### Messung des MMAP und DACP:

MMAP ist der gemischte-Methylcyclohexan-Anilin-Trübungspunkt, der unter Verwendung eines modifizierten ASTM C 611-Verfahrens bestimmt wird. Methylcyclohexan ist für das in dem Standard-Prüfverfahren verwendete Heptan eingesetzt. Das Verfahren verwendet Harz/Anilin/Methylcyclohexan in einem Verhältnis von 1/2/1 (5 g/10 ml/5 ml) und der Trübungspunkt wird durch Abkühlen einer erhitzten, klaren Mischung der drei Komponenten, bis die vollständige Trübung gerade eintritt, bestimmt

Der DACP ist der Diaceton-Trübungspunkt und wird durch Abkühlen einer erhitzten Lösung von 5 g Harz, 5 g Xylol und 5 g Diacetonalkohol bis zu dem Punkt bestimmt, bei welchem die Lösung trübe wird.

### Messung der Klebkraft:

Die Klebkräfte auf Glas wurden analog ISO 29862 (Methode 3) bei 23 °C und 50 % relativer Luftfeuchte bei einer Abzugsgeschwindigkeit von 30 mm/min und einem Abzugswinkel von 180° bestimmt. Als Verstärkungsfolie wurde eine geätzte PET-Folie mit einer Dicke von 36 µm verwendet, wie sie von der Fa. Coveme (Italien) erhältlich ist. Die Verklebung des Messtreifens wurde dabei mittels einer Anrollmaschine bei einer Temperatur von 23 °C vorgenommen. Die Klebebänder wurden sofort nach der Applikation abgezogen. Der Messwert (in N/cm) ergab sich als Mittelwert aus drei Einzelmessungen.

### Erweichungstemperatur:

Die Erweichungstemperatur von Copolymeren, Hart- und Weichblöcken und ungehärteten Reaktivharzen wird kalorimetrisch über die Differential Scanning Calorimetry (DSC) nach DIN 53765:1994-03 bestimmt. Aufheizkurven laufen mit einer Heizrate von 10 K/min. Die Muster werden in Al-Tiegeln mit gelochtem Deckel und Stickstoffatmosphäre vermessen. Es wird die zweite Aufheizkurve ausgewertet. Bei amorphen Stoffen treten Glasübergangstemperaturen auf, bei (semi)kristallinen Stoffen Schmelztemperaturen. Ein Glasübergang ist als Stufe im Thermogramm erkennbar. Die Glasübergangstemperatur wird als Mittelpunkt dieser Stufe ausgewertet. Eine Schmelztemperatur ist als Peak im Thermogramm erkennbar. Als Schmelztemperatur wird diejenige Temperatur notiert, bei der die höchste Wärmetönung auftritt.

### Molekulargewicht

Die Molekulargewichtsbestimmungen der gewichtsmittleren Molekulargewichte Mw und der zahlenmittleren Molekulargewichte Mₙ erfolgten mittels Gelpermeationschromatographie (GPC). Als Eluent wurde THF (Tetrahydrofuran) mit 0,1 Vol.-% Trifluoressigsäure eingesetzt. Die Messung erfolgte bei 25 °C. Als Vorsäule wurde PSS-SDV, 5 µ, 10³Å, ID 8,0 mm x 50 mm verwendet. Zur Auftrennung wurden die Säulen PSS-SDV, 5 µ, 10³ sowie 10⁵ Å und 10⁶ Å mit jeweils ID 8,0 mm x 300 mm eingesetzt. Die Probenkonzentration betrug 4 g/l, die Durchflussmenge 1,0 ml pro Minute. Es wurde gegen Polystyrol-Standards gemessen.

### Reißdehnung

Die Reißdehnung wird nach ISO 29864 (Methode A, 20 mm Teststreifenbreite) bei 23 °C und 50 % relativer Feuchte bestimmt. Der Test wird an 500 µm dicken Prüfmustern des Klebstoffs durchgeführt.

### Beispiele

Im Folgenden soll die Erfindung anhand von Beispielen näher erläutert werden, ohne diese damit allerdings einschränken zu wollen.

### Klebemasse

Sofern nicht anders angegeben, sind alle Mengenangaben in den nachfolgenden Beispielen Gewichtsprozente beziehungsweise Gewichtsteile bezogen auf die Gesamtzusammensetzung ohne Photoinitiator. Die Photoinitiatormenge bezieht sich auf die Menge des eingesetzten Epoxidharzes.

### Aktivierbare Haftklebemasse:

| | | |
|---|---|---|
| 33,4 Teile | SibStar 62 M | SiBS (Polystyrol-block-Polyisobutylen-Blockcopolymer) der Firma Kaneka mit 20 Gew.-% Blockpolystyrolgehalt. |
| 33,3 Teile | Uvacure 1500 | cycloaliphatisches Diepoxid der Firma Cytec Viskosität bei 23 °C etwa 300 mPas |
| 33,3 Teile | Escorez 5300 | ein vollhydriertes Kohlenwasserstoffharz der Firma Exxon |
| | | Erweichung Ring and Ball 105 °C, |
| | | DACP = 71, MMAP = 72, |
| 1 Teil | Triarylsulfonium hexafluoroantimonat | kationischer Fotoinitiator von der Firma Sigma-Aldrich |
| | | Der Photoinitiator weist ein Absorptionsmaximum im Bereich 320 nm bis 360 nm auf und lag als 50 Gew.-%-ige Lösung in Propylencarbonat vor |

Für die aktivierbare Haftklebemasse, die in den Beispielen als Klebemasse verwendet wurde, wurde als Polymerbasis ein Polystyrol-block-Polyisobutylen-Blockcopolymer der Firma Kaneka ausgewählt. Der Anteil an Styrol im Gesamtpolymer beträgt 20 Gew.-%. Die Molmasse beträgt 60.000 g/mol. Die Glasübergangstemperatur der Polystyrolblöcke beträgt 100 °C und die der Polyisobutylenblöcke -60 °C.

Als Klebharz wurde Escorez 5300, ein vollhydriertes Kohlenwasserstoffharz der Fa. Exxon, ausgewählt.

Als Reaktivharz wurde Uvacure 1500 der Firma Dow ausgewählt, ein cycloaliphatisches Diepoxid (3,4-Epoxycyclohexylmethyl 3,4-epoxycyclohexanecarboxylate). Die Glasübergangstemperatur von Uvacure 1500 beträgt -53 °C.

Diese Rohstoffe wurden bei Raumtemperatur in einem Gemisch aus Toluol (300 Teile), Aceton (150 Teile) und Siedegrenzenbenzin 60/95 (550 Teile) gelöst, so dass eine 50 Gew.-% Lösung entsteht.

Nachdem alle festen Bestandteile vollständig gelöst waren, wurden die Füllstoffe zugegeben. Durch die Verwendung eines schnellaufenden Laborrührers mit einer Dispergierscheibe wurde eine homogene Verteilung in der Klebemasse erreicht. Die eingewogenen Partikel (5% vom Feststoffgehalt der Klebemasse) wurden portionsweise in die bereits rührende Klebemasse gegeben. Nach vollständiger Zugabe wurde die Masse 30 Minuten dispergiert. Um anschließend noch vorhandene Feststoffagglomerate zu zerkleinern, wurde die Masse mittels eines Ultra-Turrax (Firma IKA) für weitere 5 Minuten bearbeitet.

Anschließend wurde der Lösung der Photoinitiator zugesetzt.

Zur Herstellung von Transferklebebändern wurden die Klebstoffe aus der Lösung auf einen konventionellen silikonisierten PET-Liner (Silphan S50 M374 der Firma Siliconature) mittels eines Laborstreichgeräts aufgebracht. Die Trocknung erfolgte zunächst bei 10-minütiger Raumtemperatur-Lagerung und anschließendem Aufenthalt in einem Trockenofen bei 120°C für weitere 10 Minuten. Unmittelbar nach der Trocknung wurden die Klebstoffschichten mit einem weiteren silikonisierten PET Liner (Silphan S50 M371) eingedeckt. Die Klebstoffschichtdicke nach dem Trocknen betrug jeweils 50 µm.

Für verschiedene Tests wurden die Klebebänder nach der Applikation im Testaufbau mittels UV-Licht gehärtet (UV-Dosis: Summe UV-A+B+C, ermittelt mit dem Power Puck der Firma EIT, von 2000 mJ/cm²). Dazu wurde eine Labor-UV-Bestrahlungsanlage der Firma Eltosch mit einem Mitteldruck-Quecksilberstrahler verwendet. Nach UV-Bestrahlung wurde der jeweilige Aufbau bei 80 °C 30 Minuten in einem Trockenschrank nachvernetzt. Folgende Füllstoffe wurden verwendet (Tabelle 3):

| | **Füllstoff** | **Beschreibung** | **Partikelgröße d50 [µm]** | **Brechungsindex (23 °C)** |
|---|---|---|---|---|
| F1 | Ceridust 9202 F | mikronisiertes niedermolekulares Polytetrafluorethylen (PTFE) der Firma Clariant | 4 | 1,35 |
| F2 | Ceridust 3920 F | PTFE modifiziertes PE-Wachs der Firma Clariant | 5 | 1,39 |
| F3 | Tospearl 3120 | mikronisiertes Silikonharz der Firma Momentive | 12 | 1,40 |
| F4 | Ceridust 2051 | mikronisiertes Kohlenwasserstoffwachs der Firma Clariant | 7 | 1,51 |
| F5 | Spheromers CA15-1 | PMMA-Kugeln der Firma Microbeads AS | 15 | 1,49 |
| F6 | Mowital B60HH | Polyvinylbutyral der Firma Kuraray mit einem Gehalt an Polyvinylalkohol von 14 Gew.-% und einem Gehalt an Polyvinylacetat von 2,5 Gew.-% | 50 | 1,48 |
| F7 | Syloid ED2 | amorphe Kieselsäure der Firma Grace | 4 | 1,44* |
| F8 | AEROSIL R972 | mit Dimethyldichlorsilan hydrophobierte pyrogene Kieselsäure der Firma Evonik | 0,016 (primär) | 1,44* |

| | | | | |
|---|---|---|---|---|
| * Literaturwert (bei etwa 20 - 30 °C) | | | | |

Die Füllstoffe F3 bis F8 führen dabei zu nicht erfindungsgemäßen Beispielen (Vergleichsbeispiele V1 - V6).

Tabelle 4 stellt die hergestellten Klebstoffe dar, die anschließend zu Transferklebebändern verarbeitet wurden. Weiterhin werden die ermittelten Werte für Haze und Transmission dargestellt.
Für Beispiel B3 wurde zusätzlich zum Füllstoff Vinyltrimethoxysilan (VTMS) als molekular dispergierbarer Getter zugesetzt.

| | | **Füllstoff** | **Anteil Füllstoff [Gew.-%]** | **Haze [%]** | **Transmission [%]** |
|---|---|---|---|---|---|
| B1 | F1 | Ceridust 9202 F | 5 | 56,9 | 90,6 |
| B2 | F2 | Ceridust 3920 F | 5 | 21,5 | 92,4 |
| B3 | F1 | Ceridust 9202 F | 5 | 54,8 | 91,2 |
| | | VTMS | 5 | | |
| B4 | F1 | Ceridust 9202 F | 1 | 16,57 | 92 |
| B5 | F1 | Ceridust 9202 F | 2,5 | 35,73 | 91,3 |
| B6 | F1 | Ceridust 9202 F | 10 | 80,43 | 89,17 |
| V1 | F4 | Ceridust 2051 | 5 | 9,7 | 92,9 |
| V2 | F5 | Spheromers CA15-1 | 5 | 13,7 | 92,6 |
| V3 | F6 | Mowital B60HH | 5 | 6,9 | 92,4 |
| V4 | F7 | Syliod ED2 | 5 | 28,8 | 92,6 |
| V5 | F8 | AEROSIL R972 | 5 | 2,3 | 92,5 |
| V6 | F3 | Tospearl 3120 | 5 | 20,1 | 92,9 |
| V7 | - | keiner | 0 | 0,61 | 93,2 |

Die Versuche zeigen, dass überraschend unterhalb eines Brechungsindex von 1,45 (Beispiele B1 - B6 sowie Vergleichsbeispiele V4 und V6) bei gleichem Füllstoffgehalt ein erheblich größerer Haze bei gleichzeitig kaum gegenüber der ungefüllten Klebemasse (V5) erhöhter Transmission erhalten wird. Besonders stark tritt dieser Effekt bei einem Brechungsindex von weniger als 1,41 (B2, V6) und ganz besonders stark bei einem Brechungsindex von weniger als 1,37 (B1, B3, B4 - B6) auf.

Der Brechungsindex der vernetzten Klebemasse wurde zu 1,53 ermittelt. Daraus ergibt sich weiterhin, dass ein Unterschied des Brechungsindexes von mehr als 0,08, insbesondere von mehr als 0,12 und besonders bevorzugt von mehr als 0,16 günstig für eine hohe Transluzenz ist. Eine bevorzugte Ausführung des Klebstoffs weist also Domänen auf, deren Brechungsindex mehr als 0,8 , insbesondere von mehr als 0,12 und besonders bevorzugt von mehr als 0,16 unterhalb dem der kontinuierlichen Phase liegt.

Beispiel B3 zeigt, dass durch ein molekular dispergierbares Gettermaterial die Transluzenz nicht beeinflusst wird. Daher wird ein solches Gettermaterial bevorzugt.

Es wurde weiterhin die Klebkraft der unvernetzten Transferklebebänder ermittelt. Tabelle 5 stellt die Ergebnisse dar:

| Beispiel | Klebkraft auf Glas [N/cm] |
|---|---|
| | vernetzter Klebstoff |
| B1 | 4,9 |
| V7 | 6,4 |

Daraus folgt, dass die Zugabe von polymeren Füllstoffen die Klebkraft nur gering vermindert. Für die Verwendung des Klebstoffs zur Verkapselung eines optoelektronischen Aufbaus ist die verbleibende Klebkraft völlig ausreichend.

Folgende Permeationsraten wurden ermittelt (normiert auf eine Dicke von 50 µm):

| Beispiel | WVTR [g/m² d] |
|---|---|
| B1 | 8,4 |
| B2 | 8,0 |
| V4 | 12,9 |
| V6 | 20,2 |
| V7 | 7,9 |

Der Vergleich der Permeationsrate der Beispiele B1 und B2 mit der ungefüllten Klebemasse (V7) zeigt nur eine geringe Veränderung, was mit den wasserabweisenden Eigenschaften des fluorhaltigen Füllstoffs erklärt werden kann. Der silikonbasierte Füllstoff F3 in V6 weist wie von Silikonen bekannt eine sehr hohe WVTR auf. Daher verschlechtert sich die WVTR des Klebstoffs deutlich. Daher sind Slikone für die Anwendung nicht geeignet, und es werden fluorhaltige Polymere bevorzugt.
Der anorganische Füllstoff in V4 ist zwar selbst nicht wasserdampfdurchlässig, erhöht aber die Polarität im Klebstoff, so dass sich die WVTR erhöht. Dies zeigt einen Nachteil von polaren anorgansichen Füllstoffen auf.

Weiterhin wurde der Lebensdauertest durchgeführt. Folgende Permeationsraten wurden ermittelt (Tabelle 6):

| Beispiel | Ca-WVTR [g/m² d] |
|---|---|
| B1 | 0,38 |
| B3 | 0,24 |
| V7 | 0,30 |

Die im Calciumtest ermittelten Permeationsraten zeigen ebenfalls, dass die Barriereeigenschaften durch die Zugabe des fluorhaltigen Polymers nur wenig verschlechtert werden (B1 vs. V7). Die weitere Zugabe eines Gettermaterials (B3) führt zu deutlich verbesserten Permeationseigenschaften.

## Patentansprüche

1. Transluzenter mehrphasiger Klebstoff enthaltend zumindest eine kontinuierliche Phase sowie dispers verteilte Domänen, wobei die zumindest eine kontinuierliche Phase eine Klebemasse auf der Basis von Styrolblockcopolymer, Polybutylen oder Polyolefin ist und
• einen Brechungsindex, wie im Prüfmethodenteil der Beschreibung bestimmt, von mehr als 1,45 und
• eine Permeationsrate für Wasserdampf, wie im Prüfmethodenteil der Beschreibung bestimmt, wobei der Wert auf eine Dicke der Klebemasse von 50 µm normiert ist, von weniger als 100 g/m²d aufweist,
und die dispersen Domänen
• mit ihrem mittleren Durchmesser in einem Größenbereich von 0,1 µm bis 50 µm vorliegen,
• in einem Gewichtsanteil von nicht mehr als 10 Gew.-% in der Klebemasse enthalten sind sowie
**gekennzeichnet dadurch, dass**
die dispersen Domänen polymerer Natur sind, eine WVTR, wie im Prüfmethodenteil der Beschreibung bestimmt, wobei der Wert auf eine Dicke von 50 µm normiert ist, von weniger als 100 g/m²d und einen Brechungsindex, wie im Prüfmethodenteil der Beschreibung bestimmt, von weniger als 1,45 aufweisen.

2. Klebstoff nach Anspruch 1,
**dadurch gekennzeichnet, dass**
der Gewichtsanteil der dispers verteilten polymeren Domänen in dem Klebstoff mehr als 1 Gew.-% beträgt,
insbesondere zwischen 1 und 5 Gew.-%, wenn der Brechungsindex der Domänen, wie im Prüfmethodenteil der Beschreibung bestimmt, unterhalb von 1,40 liegt und insbesondere zwischen 5 und 10 Gew.-%, wenn der Brechungsindex der Domänen, wie im Prüfmethodenteil der Beschreibung bestimmt, bei 1,45 liegt.

3. Klebstoff nach zumindest einem der Ansprüche 1 bis 2,
**dadurch gekennzeichnet, dass**
die polymeren dispersen Domänen einen Brechungsindex, wie im Prüfmethodenteil der Beschreibung bestimmt, von weniger als 1,41, bevorzugt von weniger als 1,37 aufweisen.

4. Klebstoff nach zumindest einem der vorhergehenden Ansprüche,
**dadurch gekennzeichnet, dass**
die kontinuierliche Phase im sichtbaren Licht des Spektrums (Wellenlängenbereich von 400 nm bis 800 nm) eine Transmission, wie im Prüfmethodenteil der Beschreibung bestimmt, von mehr als 70 % und/oder einen Haze, wie im Prüfmethodenteil der Beschreibung bestimmt, von kleiner 5,0 %, bevorzugt kleiner 2,5 % zeigt.

5. Klebstoff nach zumindest einem der vorhergehenden Ansprüche,
**dadurch gekennzeichnet, dass**
der Klebstoff bei einer Schichtdicke von 50 µm eine Wasserdampfpermeationsrate, wie im Prüfmethodenteil der Beschreibung bestimmt, von weniger als 50 g/(m²·d) und/oder eine Sauerstoffdurchtrittsrate, die bei 23 °C und 50 % relativer Luftfeuchtigkeit nach DIN 53380-Teil 3 bestimmt ist,von weniger als 5000 g/(m²·d·bar) aufweist.

6. Klebstoff nach zumindest einem der vorhergehenden Ansprüche,
**dadurch gekennzeichnet, dass**
der Klebstoff in einer 50 µm dicken Schicht ein lichtstreuender Klebstoff mit einer Lichttransmission, wie im Prüfmethodenteil der Beschreibung bestimmt, von mehr als 70 % und einem Haze, wie im Prüfmethodenteil der Beschreibung bestimmt, von mehr als 10 % ist.

7. Klebstoff nach zumindest einem der vorhergehenden Ansprüche,
**dadurch gekennzeichnet, dass**
der Klebstoff genau eine kontinuierliche Phase und genau eine disperse Phase umfasst.

8. Klebstoff nach zumindest einem der vorhergehenden Ansprüche,
**dadurch gekennzeichnet, dass**
das Polymer der dispersen polymeren Domäne Fluor enthält, vorzugsweise dass die polymeren Domänen als fluorhaltige mikrokristalline Wachse vorliegen.

9. Klebstoff nach zumindest einem der vorhergehenden Ansprüche,
**dadurch gekennzeichnet, dass**
der Klebstoff aus einer kontinuierlichen Klebemassephase und einem als dispergierte Phase verteilten partikulären Füllstoff besteht.

10. Klebstoff nach Anspruch 9,
**dadurch gekennzeichnet, dass**
die kontinuierliche Klebemassephase eine Haftklebemasse oder eine aktivierbare Klebemasse ist, insbesondere eine Haftklebemasse.

11. Klebstoff nach zumindest einem der vorhergehenden Ansprüche,
**dadurch gekennzeichnet, dass**
der Klebstoff eine Haftklebemasse oder eine aktivierbare Klebemasse ist, insbesondere eine Haftklebemasse.

12. Klebstoff nach zumindest einem der vorhergehenden Ansprüche,
**dadurch gekennzeichnet, dass**
der Klebstoff mindestens ein zur Sorption mindestens einer permeationsfähigen Substanz befähigtes Gettermaterial enthält.

13. Klebstoff nach Anspruch 12,
**dadurch gekennzeichnet, dass**
der Anteil des Gettermaterials in dem Klebstoff nicht mehr als 10 Gew.-%, bevorzugt nicht mehr als 5 Gew.-% beträgt und gleichzeitig mindestens 0,01 Gew.-%, bevorzugt mindestens 0,05 Gew.-%.

14. Klebstoff nach Anspruch 12 oder 13,
**dadurch gekennzeichnet, dass**
das Gettermaterial nanoskalig vorliegt, insbesondere derart, dass die Ausdehnung in mindestens einer Dimension nicht mehr als 500 nm, bevorzugt nicht mehr als 200 nm, sehr bevorzugt nicht mehr als 100 nm beträgt.

15. Klebstoff nach zumindest einem der vorhergehenden Ansprüche,
**dadurch gekennzeichnet, dass**
sich die wie im Prüfmethodenteil der Beschreibung bestimmten Brechungsindices der kontinuierlichen Phase und der dispersen Domänen um mehr als den Wert von 0,8, bevorzugt mehr als den Wert 0,12 und ganz besonders bevorzugt mehr als den Wert 0,16 unterscheiden.

16. Klebeband, umfassend eine Schicht eines Klebstoffs nach zumindest einem der vorherigen Ansprüche.

17. Klebeband nach Anspruch 16,
**dadurch gekennzeichnet, dass**
das Klebeband über die Schicht des Klebstoffs hinaus weitere Schichten aufweist wie weitere Klebemasseschichten, Trägermaterial oder Liner.

18. Klebeband nach Anspruch 17,
**dadurch gekennzeichnet, dass**
das Trägermaterial ein polymeres Trägermaterial ist.

19. Klebeband nach Anspruch 17,
**dadurch gekennzeichnet, dass**
das Trägermaterial mindestens eine anorganische Barriereschicht aufweist.

20. Verfahren zum Schutz einer insbesondere auf einem Substrat angeordneten organischen elektrischen Anordnung,
wobei eine Abdeckung derart auf die elektronische Anordnung aufgebracht wird, dass die elektronische Anordnung zumindest teilweise durch die Abdeckung überdeckt wird, wobei weiterhin die Abdeckung zumindest teilflächig auf dem Substrat und/oder auf der elektronischen Anordnung verklebt wird,
wobei die Verklebung mittels zumindest einer Schicht eines Klebstoffs nach zumindest einem der vorherigen Ansprüche bewirkt wird.

21. Verfahren nach Anspruch 20,
**dadurch gekennzeichnet, dass**
die Klebstoffschicht als Schicht eines Klebebands vorliegt.

22. Verfahren nach einem der vorangehenden Ansprüche,
**dadurch gekennzeichnet, dass**
zunächst die Klebstoffschicht, gegebenenfalls als Bestandteil eines weitere Schichten umfassenden doppelseitig klebenden Klebebandes, und in einem nachfolgenden Schritt die Abdeckung auf das Substrat und/oder die elektronische Anordnung aufgebracht wird.

23. Verfahren nach einem der vorangehenden Ansprüche,
**dadurch gekennzeichnet, dass**
die Klebstoffschicht und die Abdeckung gemeinsam auf das Substrat und/oder die elektronische Anordnung aufgebracht werden.

24. Verfahren nach einem der vorangehenden Ansprüche,
**dadurch gekennzeichnet, dass**
die Abdeckung die elektronische Anordnung vollständig überdeckt.

25. Verfahren nach einem der vorangehenden Ansprüche,
**dadurch gekennzeichnet, dass**
auch ein Bereich des Substrats um die elektronische Anordnung herum durch die Abdeckung ganz oder teilweise überdeckt wird.

26. Verfahren nach einem der vorangehenden Ansprüche,
**dadurch gekennzeichnet, dass**
die Klebstoffschicht die elektronische Anordnung vollständig überdeckt.

27. Verfahren nach einem der vorangehenden Ansprüche,
**dadurch gekennzeichnet, dass**
auch ein Bereich des Substrats um die elektronische Anordnung herum ganz oder teilweise durch die Klebstoffschicht überdeckt wird.

28. Klebstoff nach Anspruch 1, **gekennzeichnet dadurch, dass**
die dispersen Domänen ausgewählt sind aus der Gruppe Poly(hexafluoropropylene oxide) Poly(tetrafluoroethylene-co-hexafluoropropylene) Fluorinated Ethylene Propylene Poly(pentadecafluorooctyl acrylate) Poly(tetrafluoro-3-(heptafluoropropoxy)propyl acrylate) Poly(tetrafluoro-3-(pentafluoroethoxy)propyl acrylate) Poly(tetrafluoroethylene) Tetrafluoroethylene hexafluoropropylene vinylidene fluoride Poly(undecafluorohexyl acrylate) Perfluoroalkoxy Ethylene Tetrafluoroethylene Poly(nonafluoropentyl acrylate) Poly(tetrafluoro-3-(trifluoromethoxy)propyl acrylate) Poly(pentafluorovinyl propionate) Poly(heptafluorobutyl acrylate) Poly(trifluorovinyl acetate) Poly(octafluoropentyl acrylate) Poly(methyl 3,3,3-trifluoropropyl siloxane) Poly(pentafluoropropyl acrylate) Poly(2-heptafluorobutoxy)ethyl acrylate) Poly(chlorotrifluoroethylene) Poly(2,2,3,4,4-hexafluorobutyl acrylate) Poly(trifluoroethyl acrylate) Poly (2-(1,1,2,2-tetrafluoroethoxy)ethyl acrylate) Poly(trifluoroisopropyl methacrylate) Poly(2,2,2-trifluoro-1-methylethyl methacrylate) Poly(2-trifluoroethoxyethyl acrylate) Poly(vinylidene fluoride) Ethylene Chlorotrifluroethylene Poly(trifluoroethyl methacrylate) Poly(isobutyl methacrylate)

29. Klebstoff nach Anspruch 1, **gekennzeichnet dadurch, dass**
die dispersen Domänen ausgewählt sind aus der Gruppe Poly(hexafluoropropylene oxide)(PHFPO), Fluorinated Ethylene Propylene Polymer(FEP), Poly(tetrafluoroethylene) (PTFE), Poly(Tetrafluoroethylene hexafluoropropylene vinylidene fluoride) (THV) Perfluoroalkoxy Polymer (PFA), Poly(Ethylene Tetrafluoroethylene) (ETFE), Poly(Chlorotrifluoroethylene) (PCTFE), Poly(Vinylidene Fluoride) (PVDF) und Poly (Ethylene Chlorotrifluroethylene) (ECTFE) sowie deren Co- und Terpolymere.

## Claims

1. Translucent multiphase adhesive comprising at least one continuous phase and also dispersely distributed domains, the at least one continuous phase being an adhesive based on styrene block copolymer, polybutylene or polyolefin and having
• a refractive index, as determined in the Test Methods section of the description, of more than 1.45 and
• a water vapor permeation rate, as determined in the Test Methods section of the description, the value being standardized to an adhesive thickness of 50 µm, of less than 100 g/m²d, and the disperse domains
• being present with their average diameter in a size range from 0.1 µm to 50 µm,
• being present in a weight fraction of not more than 10 wt% in the adhesive, and also
**characterized in that**
the disperse domains are polymeric in nature, have a WVTR, as determined in the Test Methods section of the description, the value being standardized to a thickness of 50 µm, of less than 100 g/m²d, and have a refractive index, as determined in the Test Methods section of the description, of less than 1.45.

2. Adhesive according to Claim 1,
**characterized in that**
the weight fraction of the dispersely distributed polymeric domains in the adhesive is more than 1 wt%,
more particularly between 1 and 5 wt% when the refractive index of the domains, as determined in the Test Methods section of the description, is below 1.40, and more particularly between 5 and 10 wt% when the refractive index of the domains, as determined in the Test Methods section of the description, is 1.45.

3. Adhesive according to at least one of Claims 1 to 2,
**characterized in that**
the polymeric disperse domains have a refractive index, as determined in the Test Methods section of the description, of less than 1.41, preferably of less than 1.37.

4. Adhesive according to at least one of the preceding claims,
**characterized in that**
the continuous phase in the visible light of the spectrum (wavelength range from 400 nm to 800 nm) exhibits a transmittance, as determined in the Test Methods section of the description, of more than 70% and/or a haze, as determined in the Test Methods section of the description, of less than 5.0%, preferably less than 2.5%.

5. Adhesive according to at least one of the preceding claims,
**characterized in that**
the adhesive at a layer thickness of 50 µm has a water vapor permeation rate, as determined in the Test Methods section of the description, of less than 50 g/(m²·d) and/or an oxygen transmission rate, determined at 23°C and 50% relative atmospheric humidity in accordance with DIN 53380-Part 3, of less than 5000 g/ (m²·d·bar).

6. Adhesive according to at least one of the preceding claims,
**characterized in that**
the adhesive in a layer 50 µm thick is a light-scattering adhesive having a light transmittance, as determined in the Test Methods section of the description, of more than 70% and a haze, as determined in the Test Methods section of the description, of more than 10%.

7. Adhesive according to at least one of the preceding claims,
**characterized in that**
the adhesive comprises precisely one continuous phase and precisely one dispersed phase.

8. Adhesive according to at least one of the preceding claims,
**characterized in that**
the polymer of the disperse polymeric domains comprises fluorine, preferably **in that** the polymeric domains are present in the form of fluorine-containing microcrystalline waxes.

9. Adhesive according to at least one of the preceding claims,
**characterized in that**
the adhesive consists of a continuous phase of adhesive, and of a distributed particulate filler as dispersed phase.

10. Adhesive according to Claim 9,
**characterized in that**
the continuous phase of adhesive is a pressure-sensitive adhesive or an activatable adhesive, more particularly a pressure-sensitive adhesive.

11. Adhesive according to at least one of the preceding claims,
**characterized in that**
the adhesive is a pressure-sensitive adhesive or an activatable adhesive, more particularly a pressure-sensitive adhesive.

12. Adhesive according to at least one of the preceding claims,
**characterized in that**
the adhesive comprises at least one getter material capable of sorbing at least one permeable substance.

13. Adhesive according to Claim 12,
**characterized in that**
the fraction of the getter material in the adhesive is not more than 10 wt%, preferably not more than 5 wt%, and at the same time is at least 0.01 wt%, preferably at least 0.05 wt%.

14. Adhesive according to Claim 12 or 13,
**characterized in that**
the getter material is in nanoscale form, more particularly such that the extent in at least one dimension is not more than 500 nm, preferably not more than 200 nm, very preferably not more than 100 nm.

15. Adhesive according to at least one of the preceding claims,
**characterized in that**
the refractive indices, as determined in the Test Methods section of the description, of the continuous phase and of the disperse domains differ by more than a figure of 0.8, preferably more than a figure of 0.12, and very preferably more than a figure of 0.16.

16. Adhesive tape comprising a layer of an adhesive according to at least one of the preceding claims.

17. Adhesive tape according to Claim 16,
**characterized in that**
the adhesive tape, in addition to the layer of the adhesive, has further layers such as further layers of adhesive, carrier material or liner(s).

18. Adhesive tape according to Claim 17,
**characterized in that**
the carrier material is a polymeric carrier material.

19. Adhesive tape according to Claim 17,
**characterized in that**
the carrier material comprises at least one inorganic barrier layer.

20. Method for protecting an organic electrical arrangement disposed in particular on a substrate, where a cover is applied to the electronic arrangement in such a way that the electronic arrangement is at least partly covered by the cover, where additionally the cover is bonded at least over part of the area to the substrate and/or to the electronic arrangement,
where the bonding is effected by means of at least one layer of an adhesive according to at least one of the preceding claims.

21. Method according to Claim 20,
**characterized in that**
the layer of adhesive is present as a layer of an adhesive tape.

22. Method according to any of the preceding claims,
**characterized in that**
first of all the layer of adhesive, optionally as part of a double-sided adhesive tape comprising further layers, and, in a subsequent step, the liner are applied to the substrate and/or the electronic arrangement.

23. Method according to any of the preceding claims,
**characterized in that**
the layer of adhesive and the liner are applied jointly to the substrate and/or the electronic arrangement.

24. Method according to any of the preceding claims,
**characterized in that**
the liner completely covers the electronic arrangement.

25. Method according to any of the preceding claims,
**characterized in that**
a region of the substrate around the electronic arrangement as well is wholly or partly covered by the liner.

26. Method according to any of the preceding claims,
**characterized in that**
the layer of adhesive completely covers the electronic arrangement.

27. Method according to any of the preceding claims,
**characterized in that**
a region of the substrate around the electronic arrangement as well is wholly or partly covered by the layer of adhesive.

28. Adhesive according to Claim 1, **characterized in that**
the disperse domains are selected from the group of poly(hexafluoropropylene oxide) poly(tetrafluoroethylene-co-hexafluoropropylene) fluorinated ethylene propylene poly(pentadecafluorooctyl acrylate) poly(tetrafluoro-3-(heptafluoropropoxy)propyl acrylate) poly(tetrafluoro-3-(pentafluoroethoxy)propyl acrylate) poly(tetrafluoroethylene) tetrafluoroethylene hexafluoropropylene vinylidene fluoride poly(undecafluorohexyl acrylate) perfluoroalkoxy ethylene tetrafluoroethylene poly(nonafluoropentyl acrylate) poly(tetrafluoro-3-(trifluoromethoxy)propyl acrylate) poly(pentafluorovinyl propionate) poly(heptafluorobutyl acrylate) poly(trifluorovinyl acetate) poly(octafluoropentyl acrylate) poly(methyl 3,3,3-trifluoropropyl siloxane) poly(pentafluoropropyl acrylate) poly(2-heptafluorobutoxy)ethyl acrylate) poly(chlorotrifluoroethylene) poly(2,2,3,4,4-hexafluorobutyl acrylate) poly(trifluoroethyl acrylate) poly(2-(1,1,2,2-tetrafluoroethoxy)ethyl acrylate) poly(trifluoroisopropyl methacrylate) poly(2,2,2-trifluoro-1-methylethyl methacrylate) poly(2-trifluoroethoxyethyl acrylate) poly(vinylidene fluoride) ethylene chlorotrifluoroethylene poly(trifluoroethyl methacrylate) poly(isobutyl methacrylate).

29. Adhesive according to Claim 1, **characterized in that** the disperse domains are selected from the group of poly(hexafluoropropylene oxide) (PHFPO), fluorinated ethylene propylene polymer (FEP), poly(tetrafluoroethylene) (PTFE), poly(tetrafluoroethylene hexafluoropropylene vinylidene fluoride) (THV), perfluoroalkoxy polymer (PFA), poly(ethylene tetrafluoroethylene) (ETFE), poly(chlorotrifluoroethylene) (PCTFE), poly(vinylidene fluoride) (PVDF) and poly(ethylene chlorotrifluoroethylene) (ECTFE) and also co- and terpolymers thereof.

## Revendications

1. Adhésif polyphasique translucide contenant au moins une phase continue ainsi que des domaines distribués de manière dispersée, l'au moins une phase continue étant une masse adhésive à base d'un copolymère à blocs de styrène, d'un polybutylène ou d'une polyoléfine et
• présentant un indice de réfraction, déterminé comme dans la partie de méthodes d'essai de la description, supérieur à 1,45 et
• un taux de perméation pour la vapeur d'eau, déterminé comme dans la partie de méthodes d'essai de la description, la valeur étant normée sur une épaisseur de la masse adhésive de 50 µm, inférieur à 100 g/m²j,
et les domaines dispersés
• étant présents avec leurs diamètres moyens dans une plage de taille de 0,1 µm à 50 µm,
• étant contenus en une proportion en poids non supérieure à 10 % en poids dans la masse adhésive ainsi que
**caractérisé en ce que** les domaines dispersés sont de nature polymérique, présentent un WVTR, déterminé comme dans la partie de méthodes d'essai de la description, la valeur étant normée sur une épaisseur de la masse adhésive de 50 µm, inférieur à 100 g/m²j et un indice de réfraction, déterminé comme dans la partie de méthodes d'essai de la description, inférieur à 1,45.

2. Adhésif selon la revendication 1, **caractérisé en ce que** la proportion en poids des domaines polymériques distribués de manière dispersée dans l'adhésif est supérieure à 1 % en poids, en particulier entre 1 et 5 % en poids, lorsque l'indice de réfraction des domaines, déterminé comme dans la partie de méthodes d'essai de la description, se situe en dessous de 1,40 et en particulier entre 5 et 10 % en poids, lorsque l'indice de réfraction des domaines, déterminé comme dans la partie de méthodes d'essai de la description, se situe à 1,45.

3. Adhésif selon au moins l'une des revendications 1 et 2, **caractérisé en ce que** les domaines dispersés polymériques présentent un indice de réfraction, déterminé comme dans la partie de méthodes d'essai de la description, inférieur à 1,41, préférablement inférieur à 1,37.

4. Adhésif selon au moins l'une des revendications précédentes, **caractérisé en ce que** la phase continue montre une transmission dans la lumière visible du spectre (domaine de longueurs d'onde de 400 nm à 800 nm), déterminée comme dans la partie de méthodes d'essai de la description, supérieure à 70 % et/ou un trouble, déterminé comme dans la partie de méthodes d'essai de la description, inférieur à 5,0 %, préférablement inférieur à 2,5 %.

5. Adhésif selon au moins l'une des revendications précédentes, **caractérisé en ce que** l'adhésif présente un taux de perméation de la vapeur d'eau à une épaisseur de couche de 50 µm, déterminé comme dans la partie de méthodes d'essai de la description, inférieur à 50 g/(m².j) et/ou un taux de pénétration de l'oxygène, qui est déterminé à 23 °C et 50 % d'humidité relative de l'air d'après la norme DIN 53380-partie 3, inférieur à 5 000 g/(m².j.bar).

6. Adhésif selon au moins l'une des revendications précédentes, **caractérisé en ce que** l'adhésif, dans une couche d'une épaisseur de 50 µm, est un adhésif diffusant doté d'une transmission de lumière, déterminée comme dans la partie de méthodes d'essai de la description, supérieure à 70 % et un trouble, déterminé comme dans la partie de méthodes d'essai de la description, supérieur à 10 %.

7. Adhésif selon au moins l'une des revendications précédentes, **caractérisé en ce que** l'adhésif comprend exactement une phase continue et exactement une phase dispersée.

8. Adhésif selon au moins l'une des revendications précédentes, **caractérisé en ce que** le polymère des domaines polymériques dispersés contient du fluor, de préférence **en ce que** les domaines polymériques sont présents en tant que cires microcristallines contenant du fluor.

9. Adhésif selon au moins l'une des revendications précédentes, **caractérisé en ce que** l'adhésif est constitué d'une phase de masse adhésive continue et d'une charge particulaire distribuée en tant que phase dispersée.

10. Adhésif selon la revendication 9, **caractérisé en ce que** la phase de masse adhésive continue est une masse autoadhésive ou une masse adhésive activable, en particulier une masse autoadhésive.

11. Adhésif selon au moins l'une des revendications précédentes, **caractérisé en ce que** l'adhésif est une masse autoadhésive ou une masse adhésive activable, en particulier une masse autoadhésive.

12. Adhésif selon au moins l'une des revendications précédentes, **caractérisé en ce que** l'adhésif contient au moins un matériau getter apte à la sorption d'au moins une substance apte à la perméation.

13. Adhésif selon la revendication 12, **caractérisé en ce que** la proportion du matériau getter dans l'adhésif n'est pas supérieure à 10 % en poids, préférablement pas supérieure à 5 % en poids et en même temps d'au moins 0,01 % en poids, préférablement d'au moins 0,05 % en poids.

14. Adhésif selon la revendication 12 ou 13, **caractérisé en ce que** le matériau getter est présent à l'échelle nanométrique, en particulier de telle manière que l'extension dans au moins une dimension n'est pas supérieure à 500 nm, préférablement pas supérieure à 200 nm, très préférablement pas supérieure à 100 nm.

15. Adhésif selon au moins l'une des revendications précédentes, **caractérisé en ce que** les indices de réfraction déterminés comme dans la partie de méthodes d'essai de la description de la phase continue et des domaines dispersés diffèrent d'une valeur supérieure à 0,8, préférablement d'une valeur supérieure à 0,12 et tout particulièrement préférablement d'une valeur supérieure à 0,16.

16. Ruban adhésif, comprenant une couche d'un adhésif selon au moins l'une des revendications précédentes.

17. Ruban adhésif selon la revendication 16, **caractérisé en ce que** le ruban adhésif présente d'autres couches sur la couche de l'adhésif, comme d'autres couches de masse adhésive, de matériau de support ou de doublure.

18. Ruban adhésif selon la revendication 17, **caractérisé en ce que** le matériau de support est un matériau de support polymérique.

19. Ruban adhésif selon la revendication 17, **caractérisé en ce que** le matériau de support présente au moins une couche barrière inorganique.

20. Procédé pour la protection d'un dispositif électrique organique en particulier disposé sur un substrat,
un couvercle étant appliqué sur le dispositif électronique de telle manière que le dispositif électronique est au moins partiellement recouvert par le couvercle,
le couvercle étant en outre collé au moins partiellement en surface sur le substrat et/ou sur le dispositif électronique,
le collage étant réalisé au moyen d'au moins une couche d'un adhésif selon au moins l'une des revendications précédentes.

21. Procédé selon la revendication 20, **caractérisé en ce que** la couche d'adhésif est présent en tant que couche d'un ruban adhésif.

22. Procédé selon l'une quelconque des revendications précédentes, **caractérisé en ce que** tout d'abord la couche d'adhésif, éventuellement en tant que composant d'un ruban adhésif double face comprenant d'autres couches, et dans une étape ultérieure le couvercle, sont appliqués sur le substrat et/ou sur le dispositif électronique.

23. Procédé selon l'une quelconque des revendications précédentes, **caractérisé en ce que** la couche d'adhésif et le couvercle sont appliqués simultanément sur le substrat et/ou sur le dispositif électronique.

24. Procédé selon l'une quelconque des revendications précédentes, **caractérisé en ce que** le couvercle recouvre entièrement le dispositif électronique.

25. Procédé selon l'une quelconque des revendications précédentes, **caractérisé en ce qu'**également une zone du substrat autour du dispositif électronique est recouverte totalement ou partiellement par le couvercle.

26. Procédé selon l'une quelconque des revendications précédentes, **caractérisé en ce que** la couche d'adhésif recouvre entièrement le dispositif électronique.

27. Procédé selon l'une quelconque des revendications précédentes, **caractérisé en ce qu'**également une zone du substrat autour du dispositif électronique est recouverte totalement ou partiellement par la couche d'adhésif.

28. Adhésif selon la revendication 1, **caractérisé en ce que** les domaines dispersés sont choisis dans le groupe
Poly(oxyde d'hexafluoropropylène) Poly(tétrafluoroéthylène-co-hexafluoropropylène) Éthylène Propylène fluoré Poly(acrylate de pentadécafluorooctyle) Poly(acrylate de tétrafluoro-3-(heptafluoropropoxy)propyle) Poly(acrylate de tétrafluoro-3-(pentafluoroéthoxy)propyle) Poly(tétrafluoroéthylène) Tétrafluoroéthylène hexafluoropropylène fluorure de vinylidène Poly(acrylate d'undécafluorohexyle) Perfluoroalcoxy Éthylène Tétrafluoroéthylène Poly(acrylate de nonafluoropentyle) Poly(acrylate de tétrafluoro-3-(trifluorométhoxy)propyle) Poly(propionate de pentafluorovinyle) Poly(acrylate de heptafluorobutyle) Poly(acétate de trifluorovinyle) Poly(acrylate d'octafluoropentyle) Poly(méthyl-3,3,3-trifluoropropyl-siloxane) Poly(acrylate de pentafluoropropyle) Poly(acrylate de 2-heptafluorobutoxy)éthyle) Poly(chlorotrifluoroéthylène) Poly(acrylate de 2,2,3,4,4-hexafluorobutyle) Poly(acrylate de trifluoroéthyle) Poly(acrylate de 2-(1,1,2,2-tétrafluoroéthoxy)éthyle) Poly(méthacrylate de trifluoroisopropyle) Poly(méthacrylate de 2,2,2-trifluoro-1-méthyléthyle) Poly(acrylate de 2-trifluoroéthoxyéthyle) Poly(fluorure de vinylidène) Éthylène Chlorotrifluoroéthylène Poly(méthacrylate de trifluoroéthyle) Poly(méthacrylate d'isobutyle).

29. Adhésif selon la revendication 1, **caractérisé en ce que** les domaines dispersés sont choisis dans le groupe Poly(oxyde d'hexafluoropropylène) (PHFPO), Polymère d'éthylène propylène fluoré (FEP), Poly(tétrafluoroéthylène) (PTFE), Poly(Tétrafluoroéthylène hexafluoropropylène fluorure de vinylidène) (THV) Polymère Perfluoroalcoxy (PFA), Poly(Éthylène Tétrafluoroéthylène) (ETFE), Poly(Chlorotrifluoroéthylène) (PCTFE), Poly(Fluorure de Vinylidène) (PVDF) et Poly((Éthylène Chlorotrifluoroéthylène) (ECTFE) ainsi que leurs copolymères et terpolymères.
